# EUROPEAN PATENT SPECIFICATION

(11) **EP 2 392 971 B1**
(45) Date of publication and mention of the grant of the patent: **15.01.2014**
(21) Application number: 11179851.8
(22) Date of filing: 14.11.2007
(51) Int. Cl.: G03F 7/20

(54) **Surface treatment method, surface treatment apparatus, exposure method and exposure apparatus**
Oberflächenbehandlungsverfahren, Oberflächenbehandlungsvorrichtung, Belichtungsverfahren und Belichtungsvorrichtung
Procédé de traitement de surface, appareil de traitement de surface, procédé d'exposition et appareil d'exposition

(30) Priority: 16.11.2006 JP 2006310278
(43) Date of publication of application: 07.12.2011
(62) Divisional of application: 07832221.1
(73) Proprietor: Nikon Corporation, Tokyo 100-8331 (JP)
(72) Inventor: Tani, Yasuhisa, Tokyo 100-8331 (JP)
(74) Representative: Viering, Jentschura & Partner

(56) References cited:
- EP-A1- 1 628 329
- EP-A1- 1 699 072
- WO-A2-02/01621
- KR-A- 20010 061 276

## Description

### BACKGROUND

### Technical Field

The present invention relates to a surface treatment method and surface treatment apparatus of an object, an exposure method and an exposure apparatus for exposing a substrate.

Priority is claimed on Japanese Patent Application No. 2006-310278, filed November 16, 2006.

### Related Art

With respect to exposure apparatuses used in the photolithography process, an immersion exposure apparatus is known which exposes a substrate via liquid, as disclosed in PCT International Publication, No. WO 99/49504.

A surface treatment apparatus which applies heat to a thin film exposed to a nitrogen atmosphere in order to convert a hydrophilic layer into hydrophobicity is disclosed in KR 2001 0061276 A.

An exposure apparatus that projects an image of a pattern onto a substrate through a liquid to expose the substrate therewith, comprising a projection optical system which projects the image of the pattern onto the substrate and a liquid-removing mechanism which removes the liquid remaining on a part arranged in the vicinity of an image plane of the projection optical system, is disclosed in EP 168 329 A1.

WO 02/01621 discloses a method of imparting hydrophobic properties to a silica dielectric film present on a substrate.

Conventionally, various measurement members irradiated with exposing light are provided in the exposure apparatus. In immersion exposure apparatuses, it is conceivable to form the immersion region of the liquid on top of the measurement members, and to irradiate the measurement members with exposing light via the liquid. In such cases, for example, when liquid (e.g., droplets) remains on the surface of the measurement members even after conducting an operation to remove liquid from the surface of the measurement members, a variety of defects may arise due to the residual liquid.

For example, there is the possibility that the environment (temperature, humidity, cleanliness, etc.) in which the exposure apparatus is placed may change due to evaporation of the residual liquid. When temperature change occurs due to the evaporative heat of residual liquid, it is possible that the various members constituting the exposure apparatus beginning with the measurement members may undergo thermal deformation, and that the state of irradiation of the substrate with exposing light may change. Moreover, there is also the possibility that liquid adhesion marks (so-called "water marks") may form on the various members due to evaporation of the residual liquid.

When such defects occur, the performance of the exposure apparatus may deteriorate, and exposure flaws may arise.

Moreover, this applies not only to immersion exposure apparatuses, but also to manufacturing apparatuses which manufacture devices using liquid - for example, coating applicators which coat substrates with solutions containing photosensitive material and the like, or development apparatuses which conduct development of substrates after exposure using developing solution and the like. When liquid remains on the surface of the various members which configure such apparatuses, the performance of the apparatus may deteriorate, and defective devices may be manufactured.

A purpose of some aspects of the invention is to provide a surface treatment method and surface treatment apparatus which are able to inhibit liquid residue on the surface of an object. In addition, its object is to provide an exposure method and exposure apparatus which are able to inhibit liquid residue on the surface of an object, and inhibit the occurrence of exposure flaws. Furthermore, its object is to provide a device manufacturing method which is able to inhibit the occurrence of defective devices.

### SUMMARY

The invention provides a surface treatment method according to claim 1, a surface treatment apparatus according to claim 6, an exposure apparatus according to claim 7 and an exposure method according to claim 8. Further embodiments of the invention are described in the dependent claims.

Some of the aspects of the present invention adopts the following configurations which correspond to the various drawings which illustrate the embodiments. However, the codes in parentheses which are given to each component serve merely to illustrate the components, and do not limit the respective components.

According to a first aspect in accordance with the present invention, a surface treatment method of an object that has a surface with liquid repellency is provided, comprising imparting energy to the object in a state where the surface of the object is in contact with a prescribed fluid in order to reduce a surface energy of the object,
wherein the surface of the object is formed with a film of material comprising fluorine and/or intramolecular polar parts;
wherein the prescribed fluid comprises inert gas;
wherein the surface energy of the object, which had increased by an exposure light in a state where the object was in contact with a liquid which has polarity, is reduced; and wherein the impartment of energy comprises heating.

According to the first aspect of the present invention, it is possible to inhibit liquid residue on the surface of the object.

According to a second aspect in accordance with the disclosure, a surface treatment method of an object (S) having a surface formed with a liquid-repellent film (Sf) is provided, the surface treatment method including an operation that irradiates the film (Sf) with ultraviolet light (Lu) in a state where the film (Sf) has been brought into contact with a prescribed fluid, in order to restore the liquid repellency of the film (Sf) which had undergone a reduction in liquid repellency.

According to the second aspect in accordance with the disclosure, it is possible to inhibit liquid residue on the surface of the object.

According to a third aspect in accordance with the disclosure, a surface treatment apparatus of an object (S) whose surface has liquid repellency is provided, the surface treatment apparatus (80A, 80B, 80C, 80D) including a fluid supply unit (81) which supplies a prescribed fluid so that it contacts the surface of the object (S), and an energy supply unit (82A, 82B, 82C, IL) which imparts energy to the object (S) in a state where the surface of the object (S) has been brought into contact with the prescribed fluid in order to reduce the surface energy of the object (S).

According to the third aspect , it is possible to inhibit liquid residue on the surface of the object.

According to a fourth aspect in accordance with the disclosure, an exposure method which conducts exposure of a substrate (P) by irradiating the substrate (P) with exposing light (EL) via a liquid (LQ) is provided, the exposure method including an operation where the surface of an object (S) arranged at a position that allows it to be irradiated with the exposing light (EL) is treated by the surface treatment methods of the aforementioned aspects.

According to the fourth aspect, it is possible to inhibit the occurrence of exposure flaws.

According to a fifth aspect in accordance with the disclosure, an exposure method which conducts exposure of a substrate (P) by irradiating the substrate (P) with exposing light (EL) via a liquid (LQ) is provided, the exposure method including an operation which irradiates the surface of an object (S) with the exposing light (EL) via a liquid (LQ) in a state where the surface of the object (S) arranged at a position that allows it to be irradiated with the exposing light (EL) has been brought into contact with the liquid (LQ), and an operation which imparts energy to the object (S) in a state where the surface of the object (S) has been brought into contact with a prescribed fluid in order to reduce the surface energy of the object (S) which had been increased by irradiation with the exposing light (EL) in a state where the object (S) was in contact with the liquid (LQ).

According to the fifth aspect , it is possible to inhibit the occurrence of exposure flaws.

According to a sixth aspect in accordance with the disclosure, a device manufacturing method is provided which uses the exposure methods of the aforementioned aspects.

According to the sixth aspect , it is possible to inhibit the occurrence of defective devices.

According to a seventh aspect in accordance with the disclosure, an exposure apparatus which conducts exposure of a substrate (P) by irradiating the substrate (P) with exposing light (EL) via a liquid (LQ) is provided, which is an exposure apparatus (EX) provided with the surface treatment apparatus (80A, 80B, 80C, 80D) of the aforementioned aspect.

According to the seventh aspect , it is possible to inhibit the occurrence of exposure flaws.

According to an eighth aspect in accordance with the disclosure, an exposure apparatus which conducts exposure of a substrate (P) by irradiating the substrate (P) with exposing light (EL) via a liquid (LQ) is provided, the exposure apparatus (EX) including an object (S) irradiated by the exposing light (EL) in a state where it is in contact with the liquid (LQ), and a surface treatment apparatus (80A, 80B, 80C, 80D) which imparts energy to the object (S) in a state where the surface of the object (S) has been brought into contact with a prescribed fluid in order to reduce the surface energy of the object (S) which had been increased by irradiation with the exposing light (EL) in a state where the object (S) was in contact with the liquid (LQ).

According to the eighth aspect , it is possible to inhibit the occurrence of exposure flaws.

According to a ninth aspect in accordance with the disclosure, a device manufacturing method using the exposure apparatuses of the aforementioned aspects is provided.

According to the ninth aspect, it is possible to inhibit the occurrence of defective device.

According to the some aspects in accordance with the disclosure and in accordance with the present invention, it is possible to inhibit liquid residue on the surface of an object, to inhibit the occurrence of exposure flaws caused by liquid residue on the surface of an object, and to inhibit the occurrence of defective devices caused by liquid residue on the surface of an object.

### BRIEF DESCRIPTION OF THE DRAWINGS

FIG 1 is a schematic block diagram which shows the exposure apparatus of the first embodiment.
FIG 2 is a sectional side view which expands part of FIG 1.
FIG 3 is an oblique view which shows the substrate stage and measurement stage.
FIG 4 is a plan view of the substrate stage and measurement stage, viewed from above.
FIG 5 is a sectional side view which shows the vicinity of the reference plate.
FIG 6 is a sectional side view which shows the vicinity of the slit plate.
FIG 7A is a schematic view that serves to describe the parameters constituting the indices of the surface properties of the members.
FIG 7B is a schematic view that serves to describe the parameters constituting the indices of the surface properties of the members.
FIG 8 is a drawing which shows the results of an experiment conducted in order to confirm the relation of the irradiation intensity of the exposing light and the surface properties of the member.
FIG 9 is schematic block diagram which shows the surface treatment apparatus of the first embodiment.
FIG 10 is a schematic view of film irradiated with the exposing light.
FIG 11 is a schematic view of film treated by the surface treatment method of embodiment 1.
FIG 12 is schematic view that serves to describe the effects of the surface treatment method of embodiment 1.
FIG 13 is a schematic view which shows the results of an experiment conducted in order to confirm the effects of the surface treatment method of embodiment 1.
FIG 14 is a schematic block diagram which shows the surface treatment apparatus of embodiment 2.
FIG 15 is a schematic block diagram which shows the surface treatment apparatus of embodiment 3.
FIG 16 is a schematic block diagram which shows the surface treatment apparatus of embodiment 4.
FIG 17 is a schematic block diagram which shows the surface treatment apparatus of embodiment 5.
FIG 18 is a schematic view that serves to describe a temperature sensor provided in the member.
FIG 19 is a flowchart that serves to describe one example of a microdevice manufacturing process.

### DESCRIPTION OF THE REFERENCE SYMBOLS

1... substrate stage, 2... measurement stage, 5... drive system, 6... measurement system, 8... first optical element, 9... second optical element, 30... nozzle member, 31... supply port, 32... recovery port, 50... reference plate, 50f... film, 60... slit plate, 60f...film, 70... upper plate, 70f... film, 80A-80D... surface treatment apparatus, 81... fluid supply unit, 82A-82C... energy supply unit, EL... exposing light, EX... exposure apparatus, IL ... illumination system, LQ...liquid, LS...liquid immersion space, Lu...ultraviolet light, P... substrate, S ... member, Sf...film, T ... plate member, Tf... film

### DESCRIPTION OF EMBODIMENTS

Below, embodiments of the present invention are described with reference to drawings, but the present invention is not limited thereby. In the below descriptions, an XYZ orthogonal coordinate system is established, and description of the positional relations of the various components is conducted with reference to this XYZ coordinate system. A prescribed direction in a horizontal plane is considered as the X-axis direction, the direction orthogonal to the X-axis direction in the horizontal plane as the Y-axis direction, and the direction orthogonal to both the X-axis direction and Y-axis direction (i.e., the vertical direction) as the Z-axis direction. In addition, the rotational (inclinational) directions around the X axis, Y axis and Z axis are respectively considered as the θX, θY and θZ directions.

### <First embodiment>

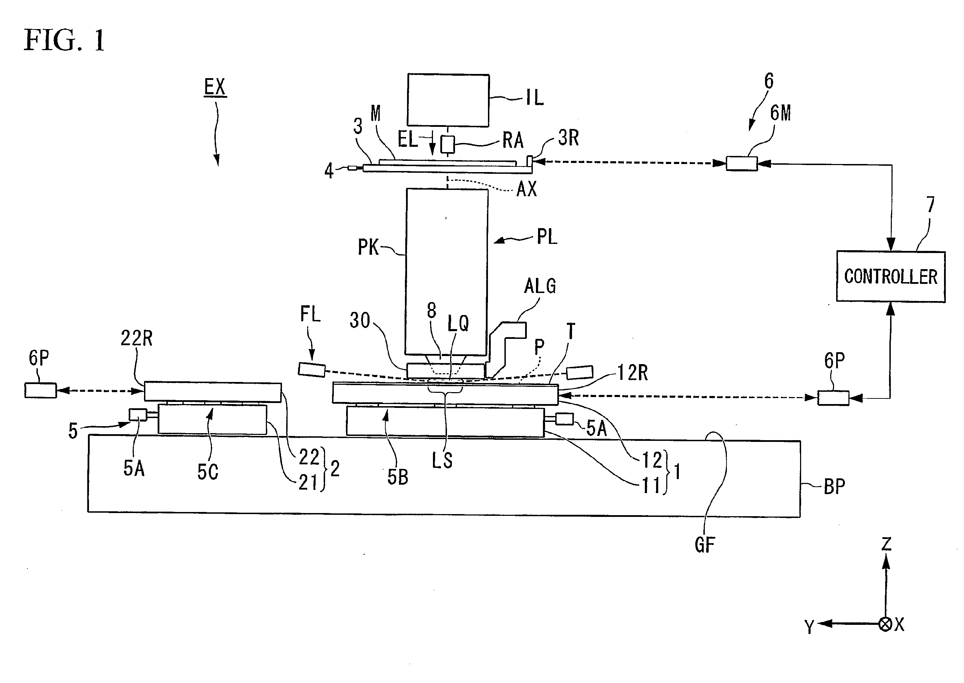

A description is now given with respect to the first embodiment. FIG 1 is a schematic block diagram showing the exposure apparatus EX pertaining to the first embodiment. In the present embodiment, the description is made based on the example where the exposure apparatus EX is an exposure apparatus provided with a substrate stage 1 which is capable of moving while holding a substrate P and a measurement stage 2 which is capable of moving and is equipped with a gauge capable of conducting measurement relating to exposure, as disclosed in, for example, Japanese Patent Application, Publication No. H11-135400 (corresponding PCT International Publication No. WO 1999/23692), Japanese Patent Application, Publication No. 2000-164504 (corresponding U. S. Patent No. 6,897,963).

In FIG 1, the exposure apparatus EX is provided with a mask stage 3 which is capable of moving while holding a mask M, a substrate stage 1 which is capable of moving while holding a substrate P, a measurement stage 2 which is capable of moving independently of the substrate stage 1 and which is equipped with a gauge and measurement members capable of conducting measurement relating to exposure without holding the substrate P, a drive system 4 which moves the mask stage 3, a drive system 5 which moves the substrate stage 1 and measurement stage 2, a measurement system 6 containing a laser interferometer which measures the positional information of each stage 1, 2 and 3, an illumination system IL which illuminates the mask M with exposing light EL, a projecting optical system PL which projects the image of the pattern of the mask M illuminated with the exposing light EL onto the substrate P, and a controller 7 which controls the operations of the entirety of the exposure apparatus EX.

The substrate P referred to here is a substrate for manufacturing a device, and includes substrates where a film Rg of photosensitive material (a photoresist) or the like is formed on a base material W such as a semiconductor wafer. The mask M includes reticles formed by a device pattern projected onto the substrate P. Moreover, a transmissive mask is used as the mask M in the present embodiment, but it is also possible to use a reflective mask.

The exposure apparatus EX is provided with a base part (block) BP which has a guide face GF that supports the substrate stage 1 and measurement stage 2 so that they are each capable of movement. The substrate stage 1 and measurement stage 2 are each capable of movement on the guide face GF. In the present embodiment, the guide face GF is substantially parallel to the XY plane, and the substrate stage 1 and measurement stage 2 are each capable of movement in the XY direction (two-dimensional directions) along the guide face GF.

The exposure apparatus EX of the present embodiment is a liquid immersion exposure apparatus which applies the immersion method in order to substantially widen depth of focus and improve resolution by substantially shortening exposure wavelength, and it is provided with a nozzle member 30 capable of forming a liquid immersion space LS of liquid LQ so that the space of the optical path of the exposure light EL is filled by the liquid LQ. The optical path space of the exposure light EL is a space that includes the optical path along which the exposure light EL advances. The liquid immersion space LS is the space which is filled by the liquid LQ. The exposure apparatus EX conducts exposure of the substrate P by irradiating the substrate P with the exposure light EL via the projecting optical system PL and the liquid LQ. In the present embodiment, water (purified water) is used as the liquid LQ.

The nozzle member 30 is capable of forming the liquid immersion space LS between itself and an object which lies opposite the nozzle member 30. In the present embodiment, the nozzle member 30 is arranged in proximity to a terminal optical element 8 which - of the multiple optical elements of the projecting optical system PL - is the closest to the image plane of the projecting optical system PL. The terminal optical element 8 has a light-emitting face (bottom face) which emits the exposure light EL, and the nozzle member 30 is capable of forming the liquid immersion space LS on the light-emitting side (image plane side of the projecting optical system PL) of the terminal optical element 8, between the nozzle member 30 and an object disposed at a position enabling irradiation with the exposure light EL, i.e., between the nozzle member 30 and an object disposed at a position opposite the light-emitting face of the terminal optical element 8. By retaining the liquid LQ between itself and the object, the nozzle member 30 forms the liquid immersion space LS of the liquid LQ so that the liquid LQ fills the optical path space of the exposure light EL on the light-emitting side of the terminal optical element 8, specifically, the optical path space of the exposure light EL between the terminal optical element 8 and the object.

Objects which are capable of facing opposite the light-emitting face of the terminal optical element 8 include objects which are capable of movement on the light-emitting side of the terminal optical element 8. In the present embodiment, objects which are capable of facing opposite the light-emitting face of the terminal optical element 8 include either one or the other of the substrate stage 1 and measurement stage 2 which are capable of movement on the light-emitting side of the terminal optical element 8. Moreover, objects which are capable of facing opposite the light-emitting face of the terminal optical element 8 also include the substrate P held on the substrate stage 1, a below-mentioned plate member T on the substrate stage 1, and measurement members (reference plate 50, slit plate 60, upper plate 70, etc.) on the measurement stage 2. The substrate stage 1 and measurement stage 2 are each capable of moving to a position which is opposite the light-emitting face of the terminal optical element 8. By retaining the liquid LQ between itself and either one or the other of the substrate stage 1 and measurement stage 2, the nozzle member 30 is able to form the liquid immersion space LS of the liquid LQ between the nozzle member 30 and terminal optical element 8 on the one hand and either the substrate stage 1 or measurement stage 2 on the other so that the optical path space of the exposure light EL on the light-emitting side of the terminal optical element 8 is filled with the liquid LQ.

In the below description, the terminal optical element 8 of the projecting optical system PL which has a light-emitting face that emits exposure light EL is referred to as the first optical element 8 for the sake of convenience, and the position opposite the light-emitting face of the first optical element 8 is referred to as the first position for the sake convenience. Accordingly, the substrate stage 1 is capable of moving within a prescribed region on the guide face GF that includes the first position opposite the light-emitting face of the first optical element 8, and the measurement stage 2 is capable of moving independently of the substrate stage 1 within a prescribed region on the guide face GF that includes the first position opposite the light-emitting face of the first optical element 8.

In the first embodiment, the nozzle member 30 forms the liquid immersion space LS between the first optical element 8 and nozzle member 30 on the one hand and the object (at least one of the substrate stage 1, measurement stage 2, substrate P, plate member T, and measurement members) on the other so that a portion of the region on the surface of the object (a local region) is covered with the liquid LQ of the liquid immersion space LS. That is, in the present embodiment, the exposure apparatus EX adopts a local immersion system which forms the liquid immersion space LS between the first optical element 8 and nozzle member 30 on the one hand and the substrate P on the other so that a portion of the region on the substrate P is covered with the liquid LQ of the liquid immersion space LS at least during exposure of the substrate P.

The illumination system IL illuminates a prescribed illumination region on the mask M with the exposure light EL which has a uniform illuminance distribution. As the exposure light EL emitted from the illumination system IL, one may use, for example, deep ultraviolet light (DUV light) such as the emission lines (g lines, h lines, i lines) emitted from a mercury lamp and KrF excimer laser light (wavelength: 248 nm), vacuum ultraviolet light (VUV light) such as ArF excimer laser light (wavelength: 193 nm) and F₂ laser light (wavelength: 157 nm), and so on. In the present embodiment, ArF excimer laser light which is ultraviolet light (vacuum ultraviolet light) is used as the exposure light EL.

By means of the drive system 4 which includes an actuator such as a linear motor, the mask stage 3 is capable of moving in the X-axis, Y-axis and θZ directions in a state where the mask M is held. The positional information pertaining to the mask stage 3 (mask M) is measured by a laser interferometer 6M of a measurement system 6. The laser interferometer 6M uses a measurement mirror 3R provided on the mask stage 3 to measure the positional information pertaining to the X-axis, Y-axis and θZ directions of the mask stage 3. The controller 7 drives the drive system 4 based on the measurement results of the measurement system 6 including the laser interferometer 6M, and controls the position of the mask M held in the mask stage 3.

The projecting optical system PL projects the image of the pattern of the mask M onto the substrate P with the prescribed projection magnification. The projecting optical system PL has multiple optical elements, and these optical elements are held in a lens barrel PK. The projecting optical system PL of the present embodiment is a reduction system where projection magnification is, for example, 1/4, 1/5, 1/8, or the like. It should be noted that the projecting optical system PL may also be an equal magnification system or an enlargement system. In the present embodiment, optical axis A of the projecting optical system PL is parallel to the Z-axis direction. Moreover, the projecting optical system PL may also be a refractive system which does not include reflective optical elements, a reflective system which does not include refractive optical elements, or a catadioptric system which includes reflective optical elements and refractive optical elements. Moreover, the projecting optical system PL may also form either inverted images or erect images.

The substrate stage 1 has a stage body 11, and a substrate table 12 mounted on the stage body 11 and capable of holding the substrate P. The stage body 11 is supported in non-contact on the guide face GF by a gas bearing, and is capable of moving in the XY direction on the guide face GF. The substrate stage 1 is capable of moving at adjacent to the light-emitting side of the first optical element 8 (the image plane side of the projecting optical system PL) in a state where the substrate P is held.

The measurement stage 2 has a stage body 21, and a measurement table 22 mounted on the stage body 21 and capable of mounting a gauge and measurement members. The stage body 21 is supported in non-contact on the guide face GF by a gas bearing, and is capable of moving in the XY direction on the guide face GF. The measurement stage 2 is capable of moving at adjacent to the light-emitting side of the first optical element 8 (the image plane side of the projecting optical system PL) in a state where a gauge is mounted.

The drive system 5 is provided with a coarse movement system 5A which includes, for example, an actuator such as a linear motor, and which is capable of moving the substrate table 12 of the stage body 11 and the measurement table 22 of the stage body 21 in the X-axis, Y-axis and θZ directions by respectively moving the stage body 11 and stage body 21 in the X-axis, Y-axis and θZ directions on the guide face GF, a fine movement system 5B which includes, for example, an actuator such as a voice coil motor, and which is capable of moving the substrate table 12 relative to the stage body 11 in the Z-axis, θX and θY directions, and a fine movement system 5C which includes, for example, an actuator such as a voice coil motor, and which is capable of moving the measurement table 22 relative to the stage body 21 in the Z-axis, θX and θY directions. The drive system 5 including the coarse movement system 5A and fine movement systems 5B and 5C is capable of respectively moving the substrate table 12 and measurement table 22 in the directions of the 6 degrees of freedom of the X-axis, Y-axis, Z-axis, θX, θY, and θZ directions. By controlling the drive system 5, the controller 7 is able to control the positions of the substrate table 12 (substrate P) and measurement table 22 (gauge) pertaining to the directions of the 6 degrees of freedom of the X-axis, Y-axis, Z-axis, θX, θ Y, and θZ directions.

The positional information of the substrate table 12 and measurement table 22 (the positional information pertaining to the X-axis, Y-axis and θZ directions) is measured by the laser interferometer 6P of the measurement system 6. The laser interferometer 6P uses measurement mirrors 12R and 22R respectively installed the substrate table 12 and measurement table 22 to measure the respective positional information of the substrate table 12 and measurement table 22 pertaining to the X-axis, Y-axis and θZ directions.

The exposure apparatus EX is provided with a focus leveling detection system FL of the oblique-incidence method. The surface position information pertaining to the surface of the substrate P held in the substrate table 12 (the position information pertaining to the Z-axis, θX and θY directions), the surface position information pertaining to the top face of the measurement table 22 and so on are detected by the focus leveling detection system FL. The measurement results of the laser interferometer 6P of the measurement system 6 and the detection results of the focus leveling detection system FL are outputted to the controller 7. Based on the measurement results of the laser interferometer 6P and the detection results of the focus leveling detection system FL, the controller 7 drives the drive system 5, and conducts positional control of the substrate P held in the substrate table 12.

The exposure apparatus EX of the present embodiment is also provided with an alignment system RA of the TTR (Through The Reticle) method using light of the exposure wavelength, which detects alignment marks on the mask M and first reference marks FM1 or the like on a reference plate 50 set in the measurement stage 2. At least a portion of the alignment system RA is disposed above the mask stage 3. The alignment system RA simultaneously observes the alignment marks on the mask M and the conjugate image via the projecting optical system PL of the first reference marks FM1 on the reference plate 50 which are set in the measurement stage 2 so as to correspond to the alignment marks. The alignment system RA of the present embodiment adopts the VRA (Visual Reticle Alignment) method which irradiates the target marks (the alignment marks on the mask M and the first reference marks FM1 or the like on the reference plate 50) with light, and detects the mark positions by conducting image processing of the image data of the marks photographed with a CCD camera or the like, as disclosed, for example, in Japanese Patent Application, Publication No. H7-176468.

The exposure apparatus EX of the present embodiment is also provided with an alignment system ALG of the off-axis method, which detects alignment marks on the substrate P and second reference marks FM2 or the like on the reference plate 50 set in the measurement stage 2. At least a portion of the alignment system ALG is disposed near the tip of the projecting optical system PL. The alignment system ALG of the present embodiment adopts an alignment system of the FIA (Field Image Alignment) method which irradiates the target marks (the alignment marks on the substrate P and the second reference marks FM2 or the like on the reference plate 50) with broadband detection light which does not photosensitize the photosensitive material on the substrate P, which uses a photographic element such as a CCD to photograph the images of indicator marks (indicator marks on an indicator plate set inside an alignment system ALG) and images of the target marks imaged on an acceptance surface by the reflective light from these target marks, and which measures the mark positions by conducting image processing of the photographic signals, as disclosed, for example, in Japanese Patent Application, Publication No. H4-65603 (corresponding U. S. Patent No. 5,493,403).

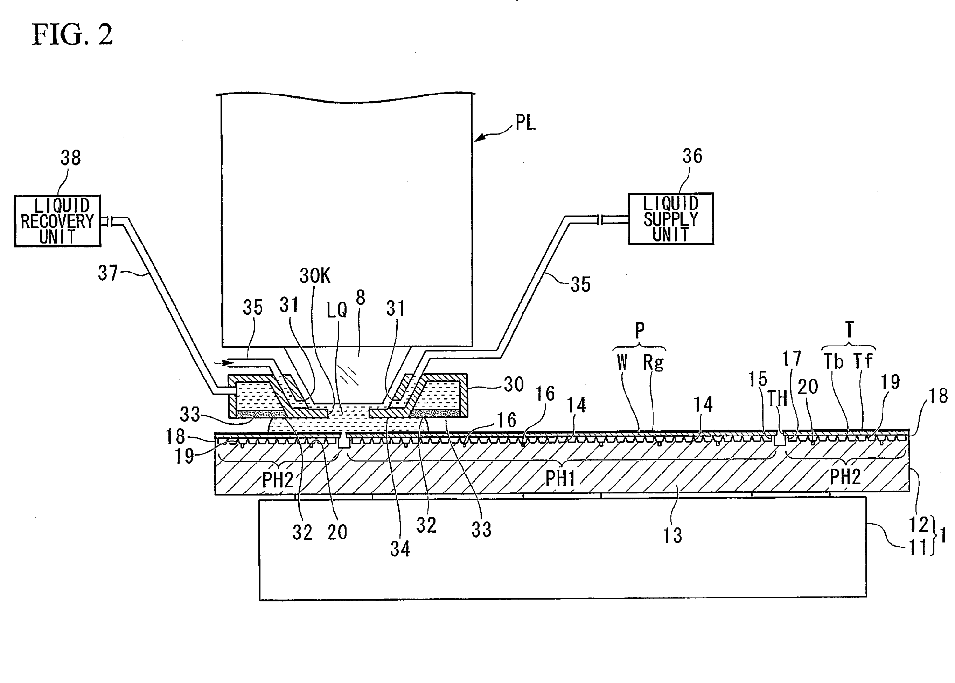

Next, a description is given of the nozzle member 30 and substrate table 12 with reference to FIG 2. FIG 2 is a sectional side view for purposes of describing the nozzle member 30 and substrate table 12.

In FIG 2, the nozzle member 30 has a supply port 31 capable of supplying the liquid LQ that serves to form the liquid immersion space LS to the optical path space of the exposure light EL, and a recovery port 32 capable of recovering the liquid LQ from at least the liquid immersion space LS. The nozzle member 30 has a bottom face capable of facing opposite the surface of the substrate P, and the liquid immersion space LS is formed by retaining the liquid LQ between the bottom face and the surface of the substrate P so that the optical path space of the exposure light EL is filled with the liquid LQ. In the present embodiment, the nozzle member 30 is an annular member formed so as to surround the first optical element 8 and the optical path space of the exposure light EL.

The recovery port 32 is disposed at the bottom face of the nozzle member 30 which faces opposite the surface of the substrate P. A porous member (mesh) 33 is arranged in the recovery port 32. The bottom face of the nozzle member 30 capable of facing opposite the surface of the substrate P includes both the bottom face of the porous member 33 and a flat face 34 disposed so as to surround an aperture 30K that allows passage of the exposure light EL. The supply port 31 is disposed at a position that is closer to the optical path space than the recovery port 32.

The supply port 31 is connected to a liquid supply unit 36 capable of feeding the liquid LQ via a supply tube 35 and a supply channel formed inside the nozzle member 30. The recovery port 32 is connected to a liquid recovery unit 38 capable of recovering the liquid LQ via a recovery tube 37 and a recovery channel formed inside the nozzle member 30.

The liquid supply unit 36 is capable of transporting the liquid LQ which is pure and temperature adjusted. The liquid recovery unit 38 is provided with a vacuum system or the like, which enables it to recover the liquid LQ. The operations of the liquid supply unit 36 and liquid recovery unit 38 are controlled by the controller 7. The liquid LQ transported by the liquid supply unit 36 flows through the supply tube 35 and the supply channel in the nozzle member 30, after which it is supplied to the optical path space of the exposure light EL from the supply port 31. Moreover, the liquid LQ recovered from the recovery port 32 by the driving of the liquid recovery unit 38 flows through the recovery channel in the nozzle member 30, after which it is recovered by the liquid recovery unit 38 via the recovery tube 37. By conducting in parallel the liquid supply operations from the supply port 31 and the liquid recovery operations from the recovery port 32, the controller 7 forms the liquid immersion space LS so that the optical path space of the exposure light EL between the first optical element 8 and the object disposed at the first position opposite the light-emitting face of the first optical element 8 is filled with the liquid LQ.

Next, the substrate table 12 is described. The substrate table 12 is provided with base material 13, a first holder PH1 which is installed in the base material 13 and which removably holds the substrate P, and a second holder PH2 which is installed in the base material 13 and which removably holds the plate member T. The plate member T is a member which is distinct from the substrate table 12, and is removably held in the second holder PH2 of the substrate table 12.

At the center of the plate member T is formed a substantially circular aperture TH which enables the disposition of the substrate P. The plate member T held by the second holder PH2 is arranged so as to surround the periphery of the substrate P held by the first holder PH1. A prescribed gap is formed between the edge (side face) of the outer side of the substrate P held by the first holder PH1 and the edge (inner side face) of the inner side (aperture TH side) of the plate member T held by the second holder PH2. In the present embodiment, the surface of the plate member T held by the second holder PH2 is a flat face that has substantially the same height (is flush with) the surface of the substrate P held by the first holder PH1.

The surface of the plate member T has liquid repellency relative to the liquid LQ. In the present embodiment, the surface of the plate member T is formed with a film Tf of material containing fluorine. Specifically, the plate member T has a base material Tb formed with metal such as stainless steel or the like, and the film Tf of material containing fluorine formed on the surface of the base material Tb. In the present embodiment, the material forming the film Tf contains PFA (tetrafluoroethylene-perfluoroalkoxyethylene copolymer).

The first holder PH1 contains a so-called pin-chuck mechanism, and is provided with multiple pin-like members 14 which are formed on top of the base material 13 and which support the rear face of the substrate P, and a first circumferential wall 15 which is formed on top of the base material 13 so as to surround the multiple pin-like members 14. The first circumferential wall 15 is formed with an annular shape which is substantially identical to the contours of the substrate P, and the top face of the first circumferential wall 15 is opposite the peripheral region (edge region) of the rear face of the substrate P. In addition, multiple first suction ports 16 which are capable of sucking in gas are provided on the base material 13 on the inner side of the first circumferential wall 15. Each of the first suction ports 16 are connected to a suction unit containing a vacuum system or the like. The controller 7 drives the suction unit, and creates negative pressure in a first space surrounded by the rear face of the substrate P, the first circumferential wall 15 and the base material 13 by having the gas of the first space sucked inward via the first suction ports 16, whereby the rear face of the substrate P is adsorptively held by the pin-like members 14. Moreover, by canceling the suction operation of the suction unit connected to the first suction ports 16, it is possible to remove the substrate P from the first holder PH1. In this manner, in the present embodiment, it is possible to removably hold the substrate P in the first holder PH1 by conducting suction operation and cancellation of suction operation using the first suction ports 16.

The second holder PH2 contains a so-called pin-chuck mechanism, and is provided with a second circumferential wall 17 which is formed on top of the base material 13 so as to encompass the first circumferential wall 15, a third circumferential wall 18 which is formed on top of the base material 13 so as to encompass the second circumferential wall 17, and multiple pin-like members 19 which are formed on top of the base material 13 between the second circumferential wall 17 and third circumferential wall 18, and which support the rear face of the plate member T. The top face of the second circumferential wall 17 is opposite the inner border region (inner edge region) of the rear face of the plate member T in the vicinity of the aperture TH. The top face of the third circumferential wall 18 is opposite the peripheral region (outer edge region) of the rear face of the plate member T.

In addition, multiple second suction ports 20 which are capable of sucking in gas are provided on the base material 13 between the second circumferential wall 17 and third circumferential wall 18. Each of the second suction ports 20 are connected to a suction unit containing a vacuum system or the like. The controller 7 drives the suction unit, and creates negative pressure in a second space surrounded by the rear face of the plate member T, the second circumferential wall 17, third circumferential wall 18, and base material 13 by having the gas of the second space sucked inward via the second suction ports 20, whereby the rear face of the plate member T is adsorptively held by the pin-like members 19. Moreover, by canceling the suction operation of the suction unit connected to the second suction ports 20, it is possible to remove the plate member T from the second holder PH2. In this manner, in the present embodiment, it is possible to removably hold the plate member T in the second holder PH2 by conducting suction operation and cancellation of suction operation using the second suction ports 20.

As shown in FIG 2, when the substrate P is irradiated with the exposing light EL via at least the liquid LQ, the plate member T is held in the second holder PH2, and is disposed around the periphery of the substrate P. When exposure processing of the substrate P is conducted, the controller 7 compels the first optical element 8 and substrate stage 1 (including the plate member T and substrate P) to face opposite each other, and irradiates the substrate P with the exposing light EL in a state where a liquid immersion space LS is formed between the first optical element 8 and substrate stage 1. For example, as shown in FIG 2, when the peripheral region (edge shot) of the surface of the substrate P is irradiated with the exposing light EL, there is the possibility that at least a portion of the plate member T will be irradiated with the exposing light EL in a state where it is in contact with the liquid LQ of the liquid immersion space LS.

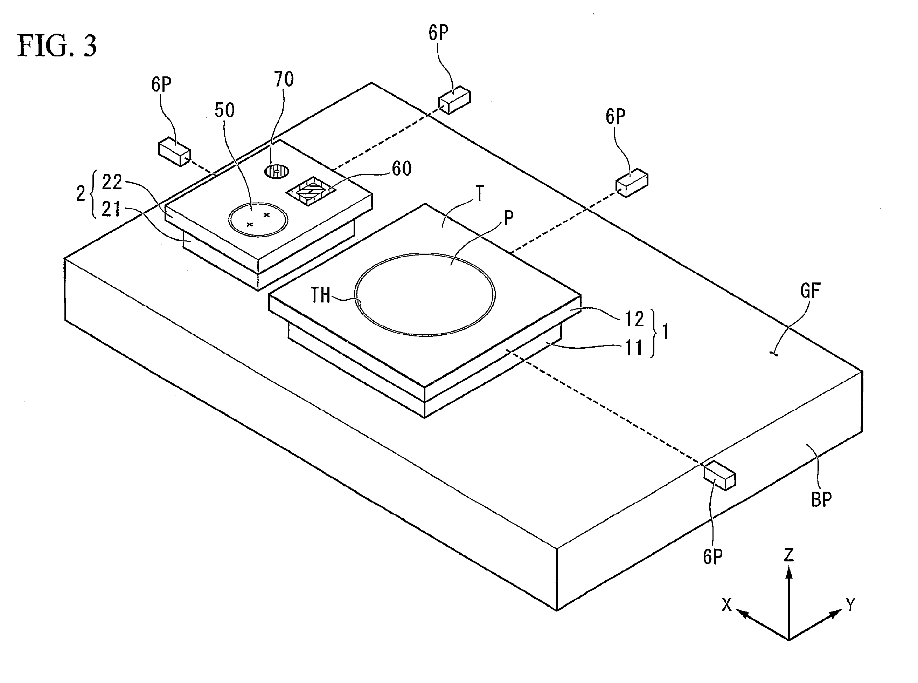

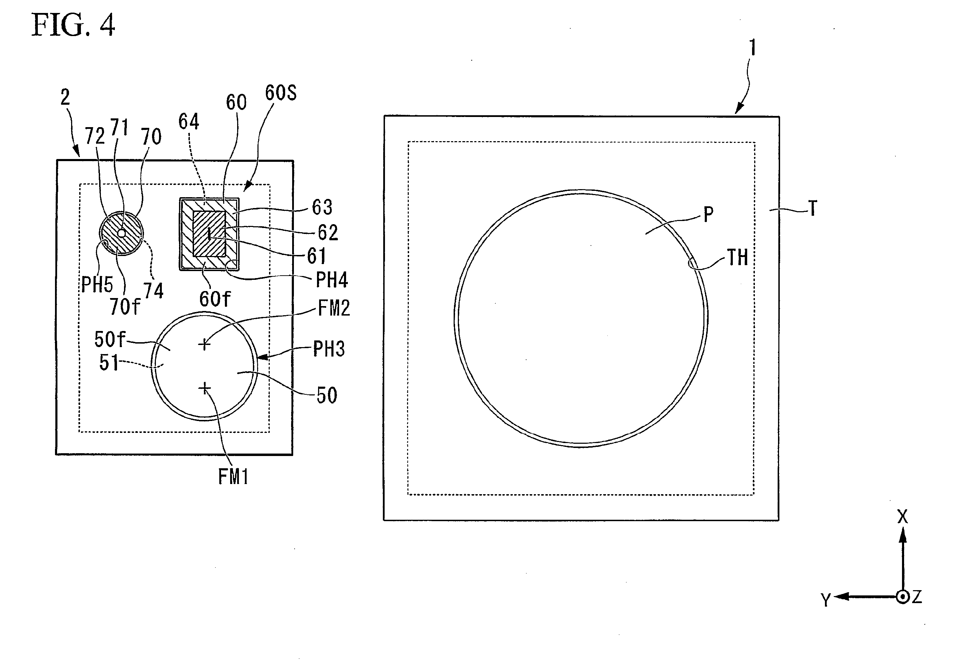

Next, the measurement stage 2 is described. FIG 3 is a schematic oblique view showing the substrate stage 1 and measurement stage 2, and FIG 4 is a plan view showing the substrate stage 1 and measurement stage 2. The measurement stage 2 is provided with multiple gauges and measurement members which serve to conduct various types of measurement relating to exposure. As a measurement member, the reference plate 50 - in which multiple reference marks FM1 and FM2 are formed - is provided at a prescribed position on top of the measurement table 22 of the measurement stage 2. In the present embodiment, the reference plate 50 is removably held in a third holder PH3 provided in the measurement table 22. As another measurement member, a slit plate 60 - in which a slit 61 is formed - is provided at a prescribed position on the top face of the measurement table 22. In the present embodiment, the slit plate 60 is removably held in a fourth holder PH4 provided in the measurement table 22. As another measurement member, an upper plate 70 - in which an aperture pattern 71 is formed - is provided at a prescribed position on the top face of the measurement table 22. In the present embodiment, the upper plate 70 is removably held in a fifth holder PH5 provided in the measurement table 22.

The reference plate 50 is provided with a base material 51 composed from low-thermal expansion material, first reference marks FM1 which are formed on top of the base material 51, and which are measured by the alignment system RA, and second reference marks FM2 which are formed on top of the base material 51, and which are measured by the alignment system ALG The first and second reference marks FM1 and FM2 are formed with metal such as Cr (chrome).

The surface of the reference plate 50 has liquid repellency relative to the liquid LQ. In the present embodiment, the surface of the reference plate 50 is formed with a film 50f of material containing fluorine. In the present embodiment, the film 50f which forms the surface of the reference plate 50 is formed with transparent material containing fluorine capable of transmitting light (the exposing light EL). As the transparent material containing fluorine that serves to form the film 50f, one may use, for example, the "CYTOP" (registered trademark) of Asahi Glass Co., Ltd.

The slit plate 60 is provided with a light-shielding film 62 composed from Cr (chrome) or the like provided at the center of the top face of the glass plate member 64, a reflective film 63 composed of aluminum or the like provided at the periphery of the light-shielding film 62, i.e., on a part of the top face of the glass plate member 64 other than the light-shielding film 62, and a slit 61 which is an aperture pattern formed in part of the light-shielding film 62. The glass plate member which is a transparent member is exposed in the slit 61, and the slit 61 is able to transmit light. As the formative material of the glass plate member 64, synthetic quartz, fluorite or the like with good transmissivity relative to the exposing light EL is used. The slit 61 can be formed, for example, by subjecting the light-shielding film 62 to etching treatment. The slit plate 60 constitutes part of a aerial image measurement system 60S as disclosed in, for example, Japanese Patent Application, Publication No. 2002-14005 (corresponding U. S. Patent Application Publication No. 2002/0041377) and Japanese Patent Application, Publication No. 2002-198303. A light-receiving element 66 constituting part of the aerial image measurement system 60S is disposed under the slit plate 60.

The surface of the slit plate 60 has liquid repellency relative to the liquid LQ. In the present embodiment, the surface of the slit plate 60 is formed with the film 60f of material containing fluorine. As the film 60f forming the surface of the slit plate 60, one may use, for example, "CYTOP" (registered trademark).

The upper plate 70 is provided with a light-shielding film 72 composed of Cr (chrome) or the like provided on the top face of a glass plate member 74, and an aperture pattern 71 formed on part of the light-shielding film 72. The glass plate member which is a transparent member is exposed in the aperture pattern 71, and the aperture pattern 71 is able to transmit light. As the formative material of the glass plate member 74, synthetic quartz, fluorite or the like with good transmissivity relative to the exposing light EL is used. The aperture pattern 71 can be formed, for example, by subjecting the light-shielding film 72 to etching treatment. The upper plate 70 constitutes part of a gauge capable of measuring illuminance irregularities as disclosed, for example, in Japanese Patent Application, Publication No. S57-117238 (corresponding U. S. Patent No. 4,465,368), an irregularity gauge designed to measure the amount of fluctuation of the transmissivity of the exposing light EL in the projecting optical system PL, as disclosed, for example, in Japanese Patent Application, Publication No. 2001-267239, and an irradiation intensity gauge (illuminance gauge) as disclosed, for example, in Japanese Patent Application, Publication No. H11-16816 (corresponding U. S. Patent Application Publication No. 2002/0061469) - all of which measure information (quantity of light, illuminance, illuminance irregularities, etc.) relating to the exposure energy of the exposing light EL. Or, the upper plate 70 may constitute part of a wavefront aberration gauge as disclosed, for example, in PCT International Publication, No. WO 99/6036 (corresponding European Patent No. 1,079,223) . A light-receiving element constituting part of these gauges is disposed under the upper plate 70.

The surface of the upper plate 70 has liquid repellency relative to the liquid LQ. In the present embodiment, as with the reference plate 50 and slit plate 60, the surface of the upper plate 70 is formed with a film 70f of, for example, "CYTOP" (registered trademark).

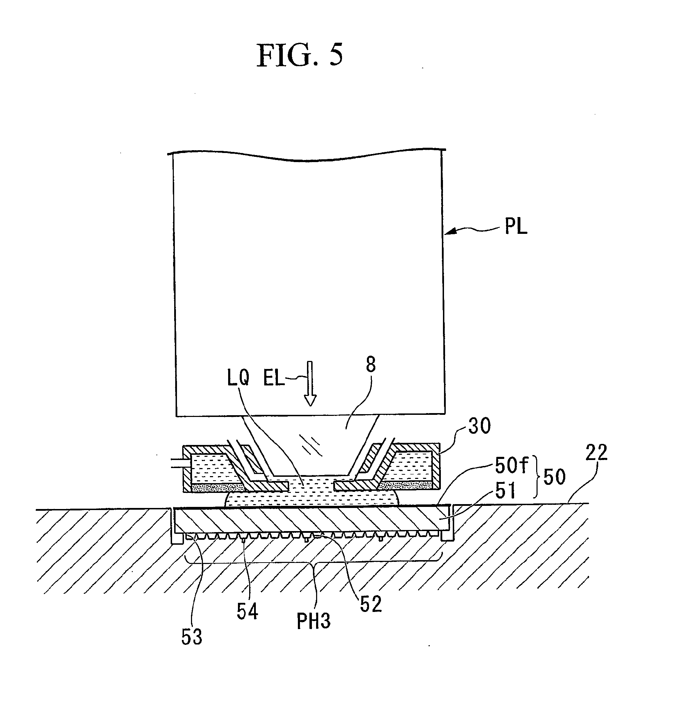

FIG 5 is a sectional view showing the reference plate 50 held in the third holder PH3. The reference plate 50 is removably held in the third holder PH3 provided in the measurement table 22. The third holder PH3 is disposed in a concavity provided in part of the top face of the measurement table 22. The third holder PH3 contains a so-called pin-chuck mechanism, and has multiple pin-like members 52 which support the rear face of the reference plate 50, a circumferential wall 53 formed so as to surround the multiple pin-like members 52, and a suction port 54 disposed on the inner side of the circumferential wall 53 and capable of sucking in gas. The top face of the reference plate 50 held in the third holder PH3 is set to substantially the same height as (flush with) the top face of the measurement table 22.

As shown in FIG 5, when measurement processing is conducted using the reference plate 50, the controller 7 compels the first optical element 8 and the reference plate 50 to face opposite each other, and irradiates the reference plate 50 with the exposing light EL or with light (ultraviolet light) of substantially the same wavelength as the exposing light (EL) in a state where the liquid immersion space LS is formed between the first optical element 8 and reference plate 50. The reference plate 50 is irradiated with the exposing light EL in a state where it is in contact with the liquid LQ of the liquid immersion space LS.

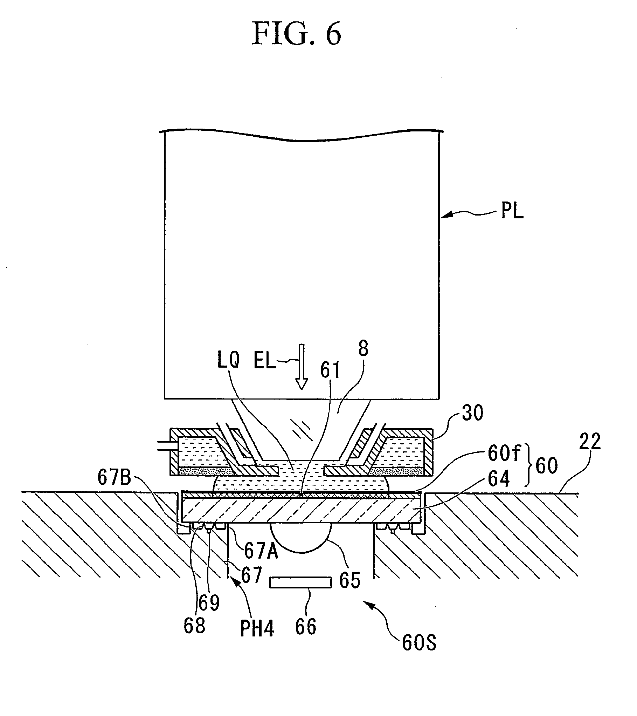

FIG 6 is a sectional view showing the slit plate 60 held in the fourth holder PH4. As shown in FIG 6, an aperture is formed in part of the top face of the measurement table 22, and an interior space which connects to the aperture is formed inside the measurement table 22. The slit plate 60 is removably held in the fourth holder PH4 disposed in proximity to the aperture of the measurement table 22. The fourth holder PH4 contains a so-called pin-chuck mechanism, and has base material 67 formed with an annular shape so as not to block the exposing light EL transmitted through the slit 61, an inner circumferential wall 67A which is formed on top of the base material 67 so as to run along the inner edge of the base material 67, an outer circumferential wall 67B which is formed on top of the base material 67 so as to surround the inner circumferential wall 67A, and multiple pin-like members 68 which are formed between the inner circumferential wall 67A and outer circumferential wall 67B, and which support the rear face of the slit plate 60, and a suction port 69 which is disposed between the inner circumferential wall 67A and outer circumferential wall 67B, and which is able to suck in gas. The top face of the slit plate 60 second circumferential wall 17 is opposite the inner border region (inner edge region) of the rear face of the plate member T in the vicinity of the aperture TH. The top face of the slit plate 60 held in the fourth holder PH4 is set to substantially the same height as (flush with) the top face of the measurement table 22.

At least part of the aerial image measurement system 60S is disposed in the interior space of the measurement table 22. The aerial image measurement system 60S is provided with the slit plate 60, an optical system 65 disposed under the slit 61 in the interior space of the measurement table 22, and a light-receiving element 66 capable of receiving light (the exposing light EL) via the optical system 65.

As shown in FIG 6, when measurement processing is conducted using the slit plate 60, the controller 7 compels the first optical element 8 and the slit plate 60 to face opposite each other, and irradiates the slit plate 60 with the exposing light EL in a state where the liquid immersion space LS is formed between the first optical element 8 and slit plate 60. The slit plate 60 is irradiated with the exposing light EL in a state where it is in contact with the liquid LQ of the liquid immersion space LS.

Although not illustrated in the drawings, a fifth holder PH5 which removably holds the upper plate 70 is provided in the measurement table 22, and the upper plate 70 is removably held in the fifth holder PH5 of the measurement table 22. The top face of the upper plate 70 held in the fifth holder PH5 and the top face of the measurement table 22 are set to have substantially the same height (to be flush).

When measurement processing is performed using the upper plate 70, the controller 7 compels the first optical element 8 and the upper plate 70 to face opposite each other, and irradiates the upper plate 70 with the exposing light EL in a state where the liquid immersion space LS has been formed between the first optical element 8 and upper plate 70. The upper plate 70 is irradiated with the exposing light EL in a state where it is in contact with the liquid LQ of the liquid immersion space LS.

In the present embodiment, apart from the top faces of the respective measurement members 50, 60 and 70, the top face of the measurement table 22 is formed with film of material containing fluorine such as PFA, and has liquid-repellency relative to the liquid LQ.

Moreover, the top face of the plate member T of the substrate table 12 and the top face of the measurement table 22 are set to have substantially the same height (to be flush).

In the case where exposure processing is performed on the substrate P held in the substrate table 12, the substrate table 12 (substrate P) is disposed at the first position which is opposite the light-emitting face of the first optical element 8, and the liquid immersion space LS is formed between the first optical element 8 and the substrate table 12 (substrate P). In the case where measurement processing is performed using the measurement table 22, the measurement table 22 is disposed at the first position which is opposite the light-emitting face of the first optical element 8, and the liquid immersion space LS is formed between the first optical element 8 and the measurement table 22. In the present embodiment - as disclosed, for example, in PCT International Publication No. WO 2005/074014 - the controller 7 simultaneously moves the substrate table 12 and measurement table 22 in the XY direction relative to the first optical element 8 using the drive system 5 in a state where the top face of the substrate table 12 (plate member T) and the top face of the measurement table 22 are in proximity or in contact in the prescribed region of the guide face GF which includes the first position opposite the light-emitting face of the first optical element 8 so that a space capable of holding the liquid LQ is continually formed between the substrate table 12 and first optical element 8 and between the measurement table 22 and first optical element 8. By this means, while inhibiting leakage of the liquid LQ, the controller 7 is able to move the liquid immersion space LS of the liquid LQ between the top face of the substrate table 12 and top face of the measurement table 22.

When conducting either exposure processing of the substrate P held in the substrate table 12 or measurement processing using the measurement table 22, the controller 7 forms the liquid immersion space LS either between the substrate table 12 and first optical element 8 or between the measurement table 22 and first optical element 8. Moreover, when one of the tables of either the substrate table 12 or measurement table 22 is distanced from the projecting optical system PL, the controller 7 positions the other table at the first position opposite the light-emitting face of the first optical element 8, with the result that it is possible to continually fill the optical path space of the exposing light EL on the light-emitting side of the first optical element 8 with the liquid LQ using the nozzle member 30.

Next, a description is given of one example of the surface treatment method pertaining to the present embodiment.

As stated above, in measurement processing using, for example, the slit plate 60, the controller 7 compels the first optical element 8 and the slit plate 60 to face opposite each other, and irradiates the slit plate 60 with the exposing light EL in a state where the liquid immersion space LS has been formed between the first optical element 8 and slit plate 60, and where the slit plate 60 is in contact with the liquid LQ. When measurement processing using the slit plate 60 terminates, the controller 7 moves the measurement stage 2 under the prescribed movement conditions (including speed, acceleration and movement direction) in order to remove the liquid LQ from the surface of the slit plate 60, and moves the slit plate 60 to a position different from the first position opposite the first optical element 8.

Even after performing the operations which remove the liquid LQ from the surface of the slit plate 60, there is the possibility that liquid LQ (e.g., droplets of the liquid LQ) may remain on the surface of the slit plate 60 according to the surface conditions of the slit plate 60. Moreover, in the case where the slit plate 60 (measurement stage 2) is moved in the XY direction under the prescribed movement conditions relative to the first optical element 8 (liquid immersion space LS), there is the possibility that it may be difficult to maintain the liquid immersion space LS (the shape of the liquid immersion space LS) in the desired state according to the surface conditions of the slit plate 60. In particular, in the case where the movement speed of the slit plate 60 (measurement stage 2) is raised for the purpose of improving through-put or the like, the possibility increases that liquid LQ may remain, that it may prove impossible to maintain the desired state of the liquid immersion space LS, and that leakage of the liquid LQ may occur.

Similarly, in measurement processing using the reference plate 50, the controller 7 compels the first optical element 8 and the reference plate 50 to face opposite each other, and irradiates the reference plate 50 with the exposing light EL in a state where the liquid immersion space LS has been formed between the first optical element 8 and reference plate 50, and where the reference plate 50 is in contact with the liquid LQ. When measurement processing using the reference plate 50 terminates, the controller 7 moves the measurement stage 2 under the prescribed movement conditions in order to remove the liquid LQ from the surface of the reference plate 50, and moves the reference plate 50 to a position different from the first position opposite the first optical element 8.

Even after performing the operations which remove the liquid LQ from the surface of the reference plate 50, there is the possibility that liquid LQ may remain on the surface of the reference plate 50 according to the surface conditions of the reference plate 50. Moreover, in the case where the reference plate 50 (measurement stage 2) is moved in the XY direction under the prescribed movement conditions relative to the first optical element 8 (liquid immersion space LS), there is the possibility that it may be difficult to maintain the liquid immersion space LS (the shape of the liquid immersion space LS) in the desired state according to the surface conditions of the reference plate 50.

Similarly, in measurement processing using the upper plate 70, the controller 7 compels the first optical element 8 and the upper plate 70 to face opposite each other, and irradiates the upper plate 70 with the exposing light EL in a state where the liquid immersion space LS has been formed between the first optical element 8 and upper plate 70, and where the upper plate 70 is in contact with the liquid LQ. With respect also to the upper plate 70, there is a possibility that liquid LQ may remain and that the desired state of the liquid immersion space LS may prove impossible to maintain according to the surface conditions of the upper plate 70.

In exposure processing of the substrate P, the controller 7 compels the first optical element 8 and the substrate stage 1 (including the plate member T and substrate P) to face opposite each other, and irradiates the substrate stage 1 with the exposing light EL in a state where the liquid immersion space LS has been formed between the first optical element 8 and substrate stage 1, and where the substrate stage 1 (including the plate member T and substrate P) is in contact with the liquid LQ. As stated above, when the peripheral region (edge shot) of the surface of the substrate P is irradiated with the exposing light EL, there exists the possibility that irradiation will be conducted with the exposing light EL in a state where at least part of the plate member T is in contact with the liquid LQ of the liquid immersion space LS. When exposure processing of the substrate P terminates, the controller 7 moves the substrate stage 1 under the prescribed movement conditions in order to remove the liquid LQ from the surface of the substrate stage 1 (including the surface of the plate member T and the surface of the substrate P), and moves the substrate stage 1 to a position different from the first position opposite the first optical element 8.

Even after performing the operations which remove the liquid LQ from the surface of the plate member T of the substrate stage 1, there is the possibility that liquid LQ (e.g., droplets of the liquid LQ) may remain on the surface of the plate member T according to the surface conditions of the plate member T. Moreover, in the case where the plate member T (substrate stage 1) is moved in the XY direction under the prescribed movement conditions relative to the first optical element 8 (liquid immersion space LS), there is the possibility that it may be difficult to maintain the liquid immersion space LS (the shape of the liquid immersion space LS) in the desired state according to the surface conditions of the plate member T. In particular, in the case where the movement speed of the plate member T (substrate stage 1) is raised for the purpose of improving through-put or the like, the possibility increases that liquid LQ may remain, that it may prove impossible to maintain the liquid immersion space LS in the desired state, and that leakage of the liquid LQ may occur.

By adjusting the surface energy of the various members such as the reference plate 50, slit plate 60, upper plate 70, plate member T, substrate table 12 and measurement table 22, the present inventors found that it is possible to inhibit liquid residue on the surface of these members after performing the operation which removes the liquid LQ from the surface of the respective members, and that it is possible to maintain the liquid immersion space LS (the shape of the liquid immersion space LS) in the desired state when the members are moved in the XY direction under the prescribed movement conditions relative to the first optical element 8 (liquid immersion space LS). That is, the present inventors found that the surface energy of members contributes to inhibition of liquid residue and to maintenance of the liquid immersion space LS in the desired state.

In the following description, members such as the reference plate 50, slit plate 60, upper plate 70, plate member T, substrate table 12 and measurement table 22 which are capable of movement to (capable of disposition at) a position opposite the light-emitting face of the first optical element 8 - i.e., a position that can be irradiated with the exposing light EL from the first optical element 8 - and which enable formation of the liquid immersion space LS between the respective member and the first optical element 8 are collectively referred to as member S for the sake of convenience.

The present inventors found that it is possible to inhibit residue of the liquid LQ on the surface of the member S after performing the operation which removes the liquid LQ from the surface of the member S by reducing the surface energy of the member S and raising the liquid repellency of the surface of the member S relative to the liquid LQ. Moreover, the present inventors found that it is possible to maintain the liquid immersion space LS (the shape of the liquid immersion space LS) in the desired state when the member S is moved in the XY direction under the prescribed movement conditions (including speed, acceleration, and movement direction) relative to the first optical element 8 (liquid immersion space LS) by reducing the surface energy of the member S and raising the liquid repellency of the surface of the member S.

Generally, the surface properties (liquid repellency) of the member S vary according to the surface energy of the member S. As parameters constituting indices of the surface properties (liquid repellency) that vary according to surface energy, one may cite the static contact angle θ, angle of descent (slide-off angle) α, receding contact angle θ _{R}, etc. of the liquid LQ on the surface of the member S. When the surface energy of the member S changes, at least one of the static contact angle θ, angle of descent α, and receding contact angle θ_{R} of the liquid LQ on the surface of the member S changes. For example, when surface energy increases, the static contact angle θ decreases, the angle of descent α increases, and the receding contact angle θ_{R} decreases. When surface energy decreases, the static contact angle θ increases, the angle of descent α decreases, and the receding contact angle θ_{R} increases.

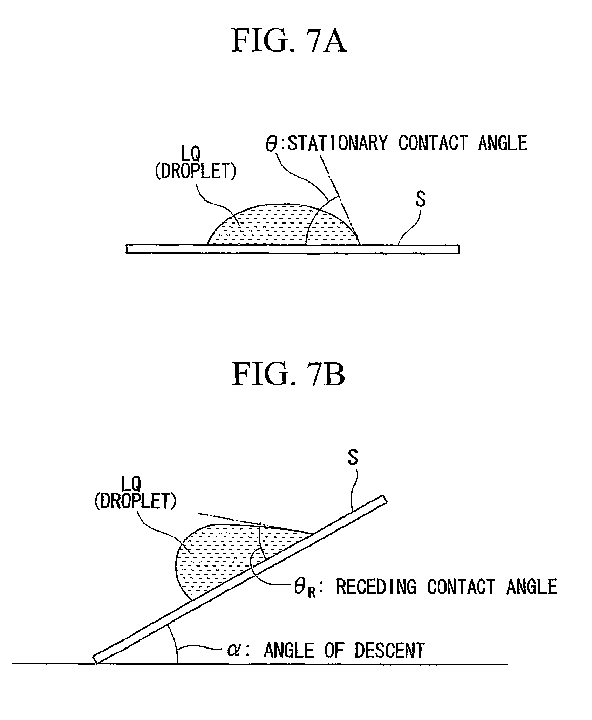

A description is now given of the static contact angle θ, angle of descent α, and receding contact angle θ_{R} with reference to FIG 7A and FIG 7B. As shown in FIG 7A, the static contact angle θ of the liquid LQ on the surface of the member S refers to the angle constituted by the surface of a droplet of the liquid LQ and the surface of the member S (taking the angle at the interior of the liquid) in a state where the droplet adheres to and is static on the surface of the member S.

As shown in FIG 7B, the angle of descent (slide-off angle) α refers to the angle when the surface of the member S is inclined relative to the horizontal plane in a state where a droplet of the liquid LQ adheres to the surface of the member S, and when the droplet of the liquid LQ that adheres to the surface of the member S starts to slide (begins to move) downward due to gravitational force. In other words, the angle of descent α refers to the critical angle at which a droplet of liquid LQ slides off when the surface of the member S to which the droplet adheres is inclined.

The receding contact angle θ_{R} refers to the contact angle of the rear side of a droplet when the surface of the member S is inclined relative to the horizontal plane in a state where a droplet of the liquid LQ adheres to the surface of the member S, and when the droplet of the liquid LQ that adheres to the surface of the member S starts to slide (begins to move) downward due to gravitational force. In other words, the receding contact angle θ_{R} refers to the contact angle of the rear side of a droplet at the critical angle of the slide-off angle α where the droplet of liquid LQ slides off when the surface of the member S to which the droplet adheres is inclined.

The time when the droplet of liquid LQ adhering to the surface of the member S starts to slide (begins to move) downward due to gravitational force signifies the moment at which the droplet begins to move, but may also include at least part of the states immediately before the beginning of movement and immediately after the beginning of movement.

The present inventors found that, in order to inhibit residue of the liquid LQ and to maintain the liquid immersion space LS in the desired state, it is good to reduce the surface energy of the member S, raise the liquid repellency of the surface of the member S, thereby increasing the static contact angle θ, decreasing the angle of descent α, and increasing the receding contact angle θ_{R} of the liquid LQ on the surface of the member S.

On the other hand, the present inventors found that the surface energy of the member S is increased by irradiating the surface of the member S with the exposing light EL when in a state in contact with the liquid LQ. In particular, the present inventors found that, of the parameters constituting indices of the surface properties (liquid repellency) that change according to surface energy, the angle of descent α increases up to or beyond a first threshold value, and the receding contact angle θ_{R} decreases down to or below a second threshold value. Here, the first and second threshold values are values pertaining to the angle of descent α and receding contact angle θ_{R} which enable inhibition of residue of the liquid LQ on the surface of the member S, and which enable maintenance of the liquid immersion space LS in the desired state. Thus, when the angle of descent α is at or above the first threshold value and when the receding contact angle θ_{R} is at or below the second threshold value, there is a high probability that defects pertaining to the residue of liquid LQ or the like will occur.

The present inventors found that the surface energy of the member S can be reduced by performing an operation which imparts energy to the member S in a state where the surface of the member S has been brought into contact with a prescribed fluid. That is, the present inventors found that the surface energy of the member S which has been increased by irradiation with exposing light EL in a state of contact with the liquid LQ can be reduced by performing an operation that imparts energy to the member S in a state where the surface of the member S has been brought into contact with a prescribed fluid.

Specifically, the present inventors found that the liquid repellency of the surface of the member S whose liquid repellency has deteriorated (declined) due to irradiation with the exposing light EL in a state of contact with the liquid LQ can be restored by irradiating the surface of the member S with, for example, ultraviolet light in a state where it has been brought into contact with a prescribed fluid such as, for example, nitrogen gas.

More specifically, the present inventors found that an angle of descent α which has increased up to or above the first threshold value due to irradiation with the exposing light EL in a state of contact with the liquid LQ can be decreased down to or below the first threshold value, and that a receding contact angle θ_{R} which has decreased down to or below a second threshold value due to irradiation with the exposing light EL in a state of contact with the liquid LQ can be increased up to or above the second threshold value.

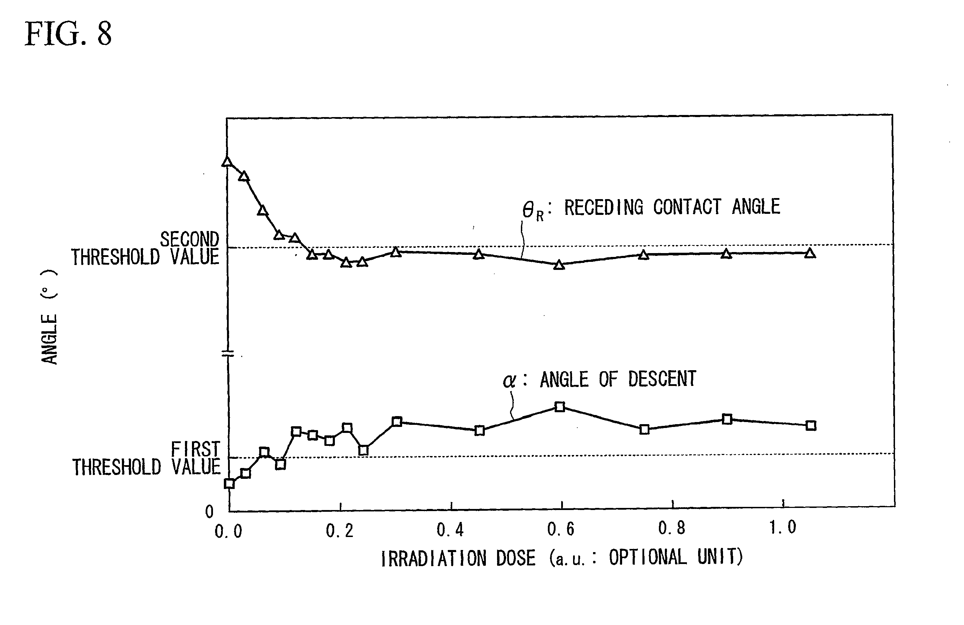

FIG 8 is a graph showing the results of an experiment conducted in order to deduce the relation of the irradiation intensity of the exposing light EL to the angle of descent α and receding contact angle θ_{R} for the case where the surface of the member S is irradiated with exposing light EL (ultraviolet light) via the liquid LQ in a state where the liquid LQ and the surface of the member S are in contact. The horizontal axis is the irradiation intensity (unit: kJ/cm²) of the exposing light (ultraviolet light) EL, and the vertical axis is the angle of the angle of descent α and receding contact angle θ_{R}. In the present experiment, the slit plate 60 was used as the sample. As stated above, the surface of the slit plate 60 is formed with a film 60f of material containing fluorine.

As shown in FIG 8, as the irradiation intensity of the exposing light EL (integrated exposure intensity) increases, it is clear that the angle of descent α increases up to or above the first threshold value, and that the receding contact angle θ_{R} decreases down to or below the second threshold value.

In order to reduce the surface energy of the member S in the surface treatment method of the present embodiment, specifically, in order to improve the liquid repellency of the surface of the member S, decrease the angle of descent α, and increase the receding contact angle θ_{R}, an operation is performed which imparts energy to the member S in a state where the surface of the member S has been brought into contact with a prescribed fluid.

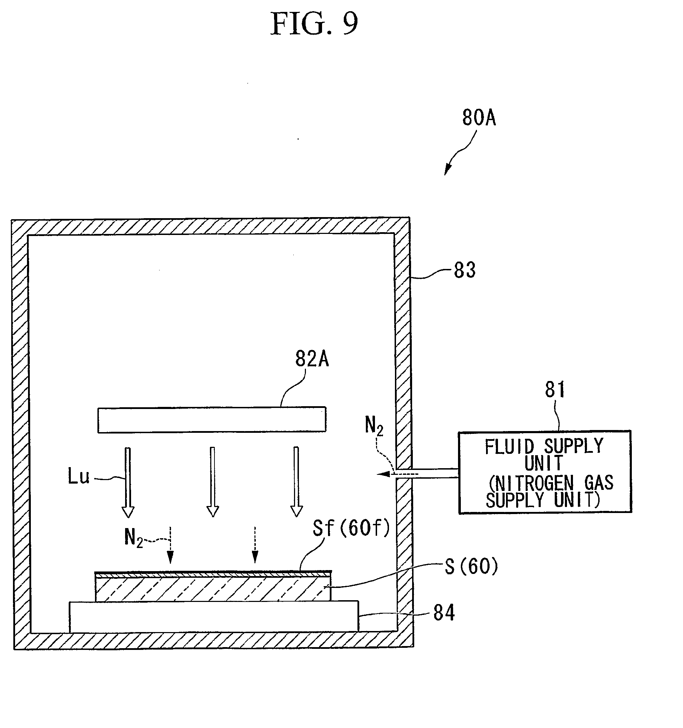

FIG 9 is a drawing which shows one example of a surface treatment apparatus 80A that serves to reduce the surface energy of the member S. In the embodiment shown in FIG 9, the slit plate 60 is used as the member S. In FIG 9, the surface treatment apparatus 80A is provided with a fluid supply unit 81 which supplies the prescribed fluid so as to contact the surface of the member S (the slit plate 60), and an energy supply unit 82A which imparts energy to the member in a state where the surface of the member S has been brought into contact with the prescribed fluid in order to reduce the surface energy of the member S. In addition, the surface treatment apparatus 80A is provided with a chamber unit 83 capable of housing the member S, and a holder member 84 which is disposed inside the chamber unit 83, and which holds the bottom face (rear face) of the member S.

The slit plate 60 which is the member S in FIG 9 is removably held in the fourth holder PH4 of the measurement table 22. When treated by the surface treatment apparatus 80A, it is removed from the fourth holder PH4, and housed inside the chamber unit 83 of the surface treatment apparatus 80A. Moreover, when the member S is treated in the surface treatment apparatus 80A, the liquid LQ is removed from the surface of the member S.

In the present embodiment, the fluid supply unit 81 includes a nitrogen gas supply unit which supplies dry nitrogen gas. The nitrogen gas supply unit 81 supplies nitrogen gas to the interior of the chamber unit 83. The nitrogen gas supplied to the interior of the chamber unit 83 by the nitrogen gas supply unit 81 is conveyed to the surface of the member S which is held in the holder member 84 inside the chamber unit 83, and comes into contact with the surface of the member S.

In the present embodiment, the energy supply unit 82A includes an ultraviolet light irradiation unit which conducts irradiation with ultraviolet light Lu. In the present embodiment, the ultraviolet light irradiation unit 82A emits light (ultraviolet light) Lu with substantially the same wavelength as the exposing light EL. As stated above, in the present embodiment, ArF excimer laser light (wavelength: 193 nm) is used as the exposing light EL, and ArF excimer laser light (wavelength: 193 nm) is used as the ultraviolet light Lu emitted from the ultraviolet light irradiation unit 82A. As the ultraviolet light Lu, it is also acceptable to use light with a shorter wavelength than the exposing light EL. For example, as the ultraviolet light Lu, it is acceptable to use ultraviolet light with a wavelength of 185 nm whose light source is a low-pressure mercury lamp.

The light-emitting face of the ultraviolet light irradiation unit 82A is disposed so as to face opposite the surface of the member S held in the holder member 84 inside the chamber unit 83. The ultraviolet light irradiation unit 82A irradiates the surface of the member S with ultraviolet light in a state where it is in contact with the nitrogen gas. By this means, the surface energy of the member S is reduced.

As stated above, the surface energy of the member S (slit plate 60) is increased as a result of irradiation with the exposing light EL in a state of contact with the liquid LQ. That is, the angle of descent α on the surface of the member S (slit plate 60) is increased as a result of irradiation with the exposing light EL in a state of contact with the liquid LQ, and the receding contact angle θ_{R} on the surface of the member S (slit plate 60) is decreased as a result of irradiation with the exposing light EL in a state of contact with the liquid LQ. In order to reduce the surface energy of the member S which has been increased as a result of irradiation with the exposing light EL in a state of contact with the liquid LQ (in order to restore the liquid repellency of the surface of the member S), the surface treatment apparatus 80A irradiates the member S with ultraviolet light Lu in a state where the surface of the member S has been brought into contact with the nitrogen gas. The surface energy of the member S is reduced as a result of the treatment conducted by the surface treatment apparatus 80A. That is, the liquid repellency of the surface of the member S is restored as a result of the treatment conducted by the surface treatment apparatus 80A, the angle of descent α on the surface of the member S is decreased as a result of the treatment conducted by the surface treatment apparatus 80A, and the receding contact angle θ_{R} on the surface of the member S is increased as a result of the treatment conducted by the surface treatment apparatus 80A.

In the present embodiment, the surface treatment operation vis-à-vis the member S using the surface treatment apparatus 80A is periodically conducted. For example, the surface treatment operation vis-à-vis the member S using the surface treatment apparatus 80A may be conducted with each prescribed number of substrates P subjected to exposure treatment, with each lot, at each prescribed time interval, etc.

Next, a description is given of the principles whereby the surface energy of the member S is reduced by irradiation with ultraviolet light.

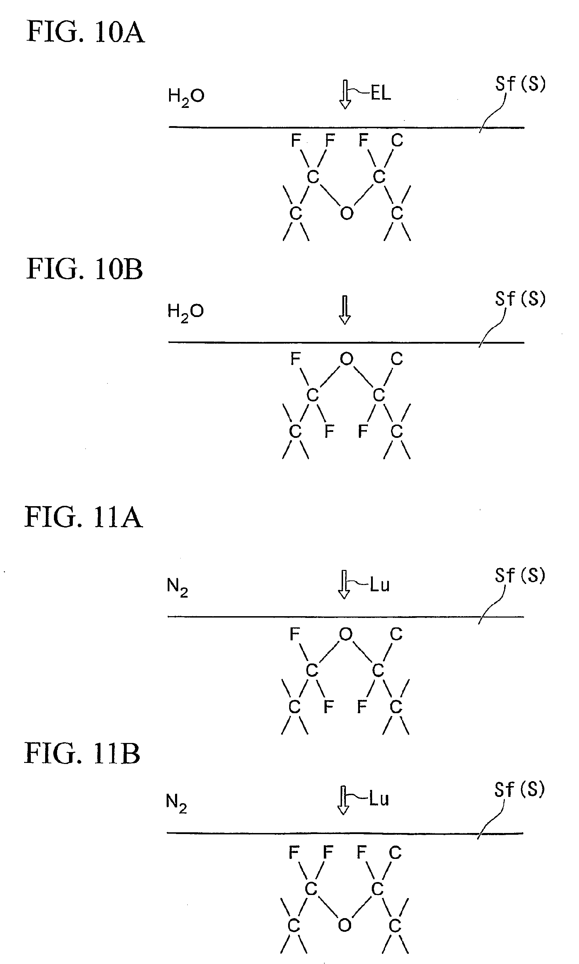

FIG 10 is a schematic drawing which shows the surface of the member S irradiated with the exposing light EL in a state of contact with the liquid LQ. In the present embodiment, the liquid LQ is water, and has polarity. The surface of the member S is formed with film Sf of material containing fluorine. The film Sf includes at least of one of the aforementioned films 50f, 60f, 70f, and Tf. The film Sf is a fluororesin (fluorinated carbon resin) whose main components are fluorine atoms and carbon atoms. As stated above, the film Sf is formed, for example, with PFA, "CYTOP" (registered trademark) or the like, and partially contains oxygen atoms and the like. Local polarity forms in the parts where the oxygen atoms bond, with the result that at least part of the film S constitutes polar molecules. The molecular structure shown in FIG 10 is but one example, and one is not limited thereto.

In the state of the initial phase before contact with the liquid LQ or before irradiation with the exposing light EL in a state of contact with the liquid LQ, the film Sf is in contact with, for example, atmospheric gas or the like. In the state of the initial phase where the film Sf is in contact with atmospheric gas or the like, fluorine atoms (fluorine groups) are disposed on the surface of the film Sf in order to reduce the interfacial energy of the film Sf and the atmosphere (gas). As a result of this disposal of fluorine atoms on the surface of the film Sf, the surface energy of the film Sf is decreased, and the surface of the film Sf is endowed with high liquid repellency.

As shown in part (A) of FIG 10, the film Sf forming the surface of the member S is irradiated with the exposing light EL in a state where the liquid LQ which has polarity and the film Sf containing molecules which have polarity (polar molecules) are in contact. Energy is imparted to the film Sf as a result of this irradiation with the exposing light EL, whereupon the movement of molecules in the film Sf is facilitated, and the interfacial molecular arrangement between the film Sf and the liquid LQ changes. In this case, as the liquid LQ has polarity, in order to reduce the interfacial energy between the film Sf and the liquid LQ, the oxygen-atom-binding sites (intramolecular polar sites) in the film Sf shift so that the intramolecular polar sites are exposed at the interface, thereby disposing the oxygen-atom-binding sites (intramolecular polar sites) on the surface of the film Sf. As a result of the disposition of oxygen-atom-binding sites (intramolecular polar sites) on the surface of the film Sf, the surface energy of the film Sf increases, and the liquid repellency of the film SF deteriorates as shown in part (B) of FIG 10.

Part (A) of FIG 11 is a schematic view which shows the surface treatment method pertaining to the present embodiment. As stated above, in the present embodiment, in order to reduce the surface energy of the member S, the surface (film Sf) of the member S is irradiated with ultraviolet light Lu in a state where the surface (film Sf) of the member S is in contact with nitrogen gas, as shown in part (A) of FIG. 11. The nitrogen gas is a fluid which has less polarity than the liquid (water) LQ, and is almost nonpolar. In the present embodiment, the film Sf forming the surface of the member S is irradiated with ultraviolet light Lu in a state where the surface (film Sf) of the member S is in contact with the almost nonpolar nitrogen gas. As a result of the irradiation with ultraviolet light Lu, energy is imparted to the film Sf, whereupon the movement of molecules in the film Sf is facilitated, and the interfacial molecular arrangement between the film Sf and the nitrogen gas changes. In this case, in order to reduce the interfacial energy between the film Sf and the nitrogen gas, the oxygen-atom-binding sites (intramolecular polar sites) in the film Sf shift so that the intramolecular polar sites are concealed from the interface, and separated from the nitrogen gas, as shown in part (B) of FIG 11, thereby disposing the fluorine atoms (fluorine groups) on the surface of the film Sf. As a result of the disposition of fluorine atoms (fluorine groups) on the surface of the film Sf, the surface energy of the film Sf decreases, and the liquid repellency of the film SF is restored.

Thus, the surface of the member S is irradiated with the exposing light EL via the liquid LQ in a state where the surface of the member S and the liquid LQ are in contact, and the liquid LQ is then removed from the surface of the member S, after which the surface of the member S is irradiated with ultraviolet light Lu in a state where the surface of the member S is in contact with nitrogen gas, whereby the surface energy of the member S which had temporarily increased due to irradiation with the exposing light EL in a state of contact with the liquid LQ is able to be reduced.

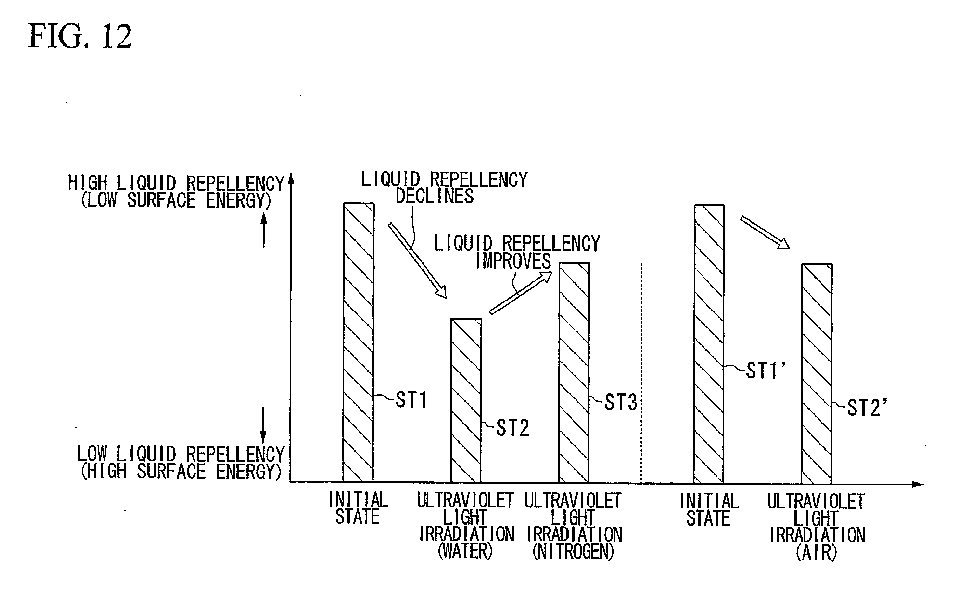

FIG 12 is a schematic view for purposes of describing the effects of the surface treatment method pertaining to the present embodiment. The graph ST1 of FIG. 12 shows surface energy in the initial state. In this initial stage, the film Sf is in contact with, for example, atmospheric gas or the like. In the initial state where the film Sf is in contact with atmospheric gas, the surface energy of the film Sf is small, and the surface of the film Sf has a high liquid repellency.

As shown in graph ST2 of FIG 12, when the film Sf is irradiated with the exposing light EL in a state where the film Sf is in contact with the liquid LQ which has polarity, the surface energy of the film Sf markedly increases, and the liquid repellency of the film Sf deteriorates (decreases).

Subsequently, after the liquid LQ is removed from the surface of the member S (film Sf), when the film Sf is irradiated with ultraviolet light Lu in a state where the film Sf is in contact with nitrogen gas, it is possible to reduce the surface energy of the film Sf, and restore the liquid repellency of the film S, as shown in graph ST3 of FIG 12.

By conducting irradiation with the exposing light EL (ultraviolet light) relative to the film Sf of the initial state shown in graph ST1' of FIG 12 in a state where the film Sf has been brought into contact with the atmosphere but not with the liquid LQ, there is the possibility that the surface energy of the film Sf will increase, and that liquid repellency of the film Sf will deteriorate, as shown in graph ST2' of FIG 12. However, one may consider that the difference between the surface energy of the film Sf in the initial state ST1' and the surface energy of the film Sf in the state ST2' after irradiation with the exposing light EL in a state of contact with the atmosphere (the amount of increase in the surface energy of the film Sf of state ST2' relative to the initial state ST1') is smaller than the difference between the surface energy of the film Sf in the initial state ST1 and the surface energy of the film Sf in the state ST2 after irradiation with the exposing light EL in a state of contact with the liquid LQ (the amount of increase in the surface energy of the film Sf of state ST2 relative to the initial state ST1). Accordingly, by using the surface treatment method of the present embodiment to treat the surface of the film Sf whose surface energy has markedly increased due to irradiation with the exposing light EL (ultraviolet light) in a state of contact with the liquid LQ, it is possible to restore the surface energy of the film Sf (angle of descent α and receding contact angle θ_{R}) to the threshold levels (first threshold value and second threshold value).

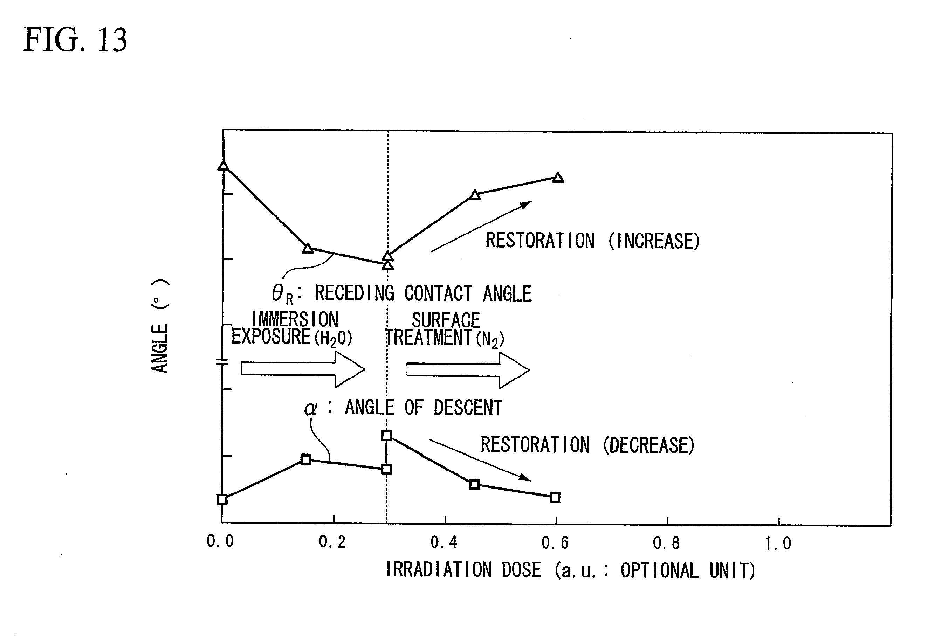

FIG. 13 is a schematic view which shows the results of an experiment conducted in order to confirm the effects of the surface treatment method pertaining to the present embodiment. The experiment respectively conducted an operation where the surface of the member S is irradiated with the exposing light EL (ultraviolet light) in a state of contact with the liquid LQ, and an operation where the surface of the member S is irradiated with the ultraviolet light Lu in a state of contact with nitrogen gas in order to reduce the surface energy of the member S after the liquid LQ has been removed from the surface of the member S. FIG. 13 is a drawing which shows the experimental results of measurement of the angle of descent α and receding contact angle θ_{R} on the surface of the member S in the experiment. As shown in FIG 13, as a result of irradiating the surface (film Sf) of the member S with the exposing light EL in a state of contact with the liquid LQ, the angle of descent α increases, and the receding contact angle θ_{R} decreases. Subsequently, after removal of the liquid LQ from the surface (film Sf) of the member S, as a result of irradiation with ultraviolet light Lu in a state where the surface (film Sf) of the member S is in contact with nitrogen gas, the angle of descent α decreases, and the receding contact angle θ_{R} increases. In this manner, it was confirmed that it is possible to reduce the surface energy of the member S by irradiating it with ultraviolet light Lu in a state where the surface (film Sf) of the member S has been brought into contact with nitrogen gas.

In the present embodiment, a description was given of an example of the case where the member S treated by the surface treatment apparatus 80A is the slit plate 60, but it goes without saying that it is also possible to treat the reference plate 50, upper plate 70, plate member T and the like with the surface treatment apparatus 80A, and reduce their surface energy (restore liquid repellency). As stated above, the plate member T is removably held in the second holder PH2 of the substrate table 12, and can be removed from the second plate holder PH2. Consequently, when the plate member T is subjected to treatment by the surface treatment apparatus 80A, it is possible to house the plate member T inside the chamber unit 83 of the surface treatment apparatus 80A by removing it from the second holder PH2. Similarly, the reference plate 50 is removably held in the third holder PH3, and the upper plate 70 is removably held in the fifth holder PH5. Consequently, when the reference plate 50 and upper plate 70 are treated by the surface treatment apparatus 80A, they can be housed inside the chamber unit 83 by removing them from the third holder PH3 and fifth holder PH5.

Below, a description is given of one example of an operation where the substrate P is irradiated using the exposure apparatus EX having the configuration described above.

First, the controller 7 fills the optical path space of the exposing light EL with the liquid LQ using the nozzle member 30 in a state where the first optical element 8 faces opposite either the substrate stage 1 or measurement stage 2.

Before subjecting the substrate P to exposure, the controller 7 measures the image-formation properties of the projecting optical system PL using the aerial image measurement system 60S. When conducting measurement processing using the aerial image measurement system 60S, a mask having an aerial image measurement pattern is held in the mask stage 3. The aerial image measurement pattern may be formed on part of the mask M which forms a device pattern that serves to manufacture a device, or it may be formed on a special-purpose mask designed for the conduct of aerial image measurement. In the case where a special-purpose mask is used, the mask M that serves to form a device is, of course, held in the mask stage 3 at the time when the substrate P is irradiated for purposes of manufacturing the device. Moreover, the substrate P that serves to manufacture the device is preloaded and held in the substrate stage 1.

The controller 7 controls the positioning of the measurement stage 2 so that the slit 61 is covered by the liquid LQ, and forms the liquid immersion space LS between the first optical element 8 and the slit plate 60 using the nozzle member 30.

As shown in FIG 6, the controller has the exposing light EL emitted from the illumination system IL. After the exposing light EL has transited the mask, projecting optical system PL and the liquid LQ of the liquid immersion space LS, it irradiates the slit plate 60. The exposing light EL that has transited the slit 61 of the slit plate 60 is received by the light-receiving element 66 via the optical system 65. In this manner, the light-receiving element 66 of the aerial image measurement system 60S receives the exposing light EL via the projecting optical system PL, the liquid LQ of the liquid immersion space LS, and the slit 61. The light-receiving element 66 outputs optoelectrical conversion signals (light intensity signals) to the controller 7 via a signal processing unit according to the quantity of received light. The controller 7 conducts the prescribed arithmetic processing based on the light-reception results of the light-receiving element 66, and obtains the image-formation properties via the projecting optical system PL and liquid LQ.

After measurement processing using the aerial image measurement system 60S has been completed, the controller 7 performs measurement processing using the upper plate 70 as necessary. When measurement processing is performed using the upper plate 70, the controller moves the measurement stage 2 in the XY direction, compels the first optical element 8 and upper plate 70 to face opposite each other, and forms the liquid immersion space LS between the first optical element 8 and the upper plate 70. The controller 7 then irradiates the aperture pattern 71 of the upper plate 70 with the exposing light EL via the projecting optical system PL and the liquid LQ of the liquid immersion space LS, and measures the exposing light EL using the light-receiving element provided underneath the aperture pattern 71.

The controller 7 then conducts adjustment processing (calibration processing) of the image-formation properties of the projecting optical system PL based on measurement processing and the like using the aerial image measurement system 60S.

In addition, the controller 7 moves the measurement stage 2 in the XY direction, compels the first optical element 8 and reference plate 50 to face opposite each other, and forms the liquid immersion space LS between the first optical element 8 and the reference plate 50. The controller 7 then adjusts the position of the measurement stage 2 in the XY direction, and disposes the first reference marks FM1 on the reference plate 50 of the measurement stage 2 in the detection region of the alignment system RA. While measuring the positional information of the measurement stage 2 using the measurement system 6 containing the laser interferometer 6P, the controller 7 detects the first reference marks FM1 on the reference plate 50 of the measurement stage 2 via the projecting optical system PL and the liquid LQ using the alignment system RA. Specifically, in a state where the area between the projecting optical system PL and the reference plate 50 on which the first reference marks are provided is filled with the liquid LQ, the controller 7 detects the first reference marks FM1 on the reference plate 50 and the corresponding alignment marks on the mask M, and detects the positional relation of the first reference marks FM1 and the corresponding alignment marks on the mask M. By this means, the controller 7 is able to obtain the positional information pertaining to the first reference marks FM1 in the coordinate system provided by the measurement system 6 containing the laser interferometer 6P. Moreover, as the alignment marks and the pattern on the mask M are formed with the prescribed positional relation, the controller 7 is able to obtain the positional relation of the first reference marks FM1 and the projection position of the pattern image.

In addition, the controller 7 adjusts the position of the measurement stage 2 in the XY direction, and disposes the second reference marks FM2 on the reference plate 50 of the measurement stage 2 in the detection region of the alignment system ALG While measuring the positional information of the measurement stage 2 using the measurement system 6 containing the laser interferometer 6P, the controller 7 detects the second reference marks FM2 on the reference plate 50 of the measurement stage 2 without interposition of the liquid LQ using the alignment system ALG By this means, the controller 7 is able to obtain the positional information pertaining to the second reference marks FM2 in the coordinate system provided by the measurement system 6 containing the laser interferometer 6P. Moreover, the alignment system ALG has a detection reference position within the coordinate system provided by the measurement system 6 containing the laser interferometer 6P, and the controller 7 is able to obtain the positional relation of the second reference marks FM2 and the detection reference position of the alignment system ALG

The first reference marks FM1 and second reference marks FM2 on the reference plate 50 are formed with a prescribed positional relation, and the prescribed positional relation of the first reference marks FM1 and second reference marks FM2 is known. Based on the positional relation of the detection reference position of the alignment system ALG and the second reference marks FM2, the positional relation of the projection position of the pattern image and the first reference marks FM1, and known positional relation of the first reference marks FM1 and second reference marks FM2, the controller 7 is able to deduce the positional relation (baseline information) of the detection reference position of the alignment system ALG in the coordinate system provided by the measurement system 6 containing the laser interferometer 6P and the projection position of the pattern image of the mask M. It is acceptable to conduct detection of the second reference marks FM2 by the alignment system ALG after detection of the first reference marks FM1 by the alignment system RA, and it is also acceptable to simultaneously conduct detection of the first reference marks FM1 by the alignment system RA and detection of the second reference marks FM2 by the alignment system ALG

After completion of measurement using the measurement stage 2, the controller 7 commences alignment processing relative to the substrate P on the substrate stage 1. The controller 7 moves the substrate stage 1 in the XY direction, and sequentially arranges the multiple alignment marks provided so as to correspond to the respective shot regions on the substrate P in the detection region of the alignment system ALG While measuring the positional information of the substrate stage 1 using the measurement system 6 containing the laser interferometer 6P, the controller 7 sequentially detects the multiple alignment marks on the substrate P without interposition of the liquid LQ using the alignment system ALG By this means, the controller 7 is able to obtain the positional information pertaining to the alignment marks on the substrate P in the coordinate system provided by the measurement system 6 containing the laser interferometer 6P. Moreover, the controller 7 is able to obtain the positional relation of the alignment marks and the detection reference position of the alignment system ALG

Next, based on the positional information of the respective alignment marks on the substrate P, the controller 7 conducts arithmetic processing to obtain the respective positional information of the multiple shot regions on the substrate P relative to the detection reference position of the alignment system ALG When obtaining the respective positional information of the multiple shot regions on the substrate P by arithmetic processing, it can be obtained using a so-called EGA (Enhanced Global Alignment) method like that disclosed in, for example, Japanese Patent Application, Publication No. S61-44429. By this means, the controller 7 is able to detect the alignment marks on the substrate P by the alignment system ALG, and to determine the respective positional coordinates (alignment coordinates) of the multiple shot regions provided on the substrate P. Moreover, based on the outputs of the measurement system 6 containing the laser interferometer 6P, the controller 7 is able to know where the respective shot regions are located on the substrate P relative to the detection reference position of the alignment system ALG

Based on the positional relation of the respective shot regions on the substrate P and the detection reference position of the alignment system ALG in the coordinate system provided by the measurement system 6 containing the laser interferometer 6P (the alignment information of the shot regions relative to the detection reference position), and the positional relation of the projection position of the pattern image of the mask M and the detection reference position of the alignment system ALG in the coordinate system provided by the measurement system 6 containing the laser interferometer 6P, the controller 7 deduces the relation of the projection position of the pattern image of the mask M and the respective shot regions of the substrate P in the coordinate system provided by the measurement system 6 containing the laser interferometer 6P.

Based on the positional relation of the respective shot regions on the substrate P and the projection position of the pattern image of the mask M, the controller 7 controls the position of the substrate P on the substrate stage 1, and sequentially exposes the multiple shot regions on the substrate P.

At least during projection of the pattern image of the mask M onto the substrate P, the controller 7 forms the liquid immersion space LS using the nozzle member 30 so that the liquid LQ fills the optical path space of the exposing light EL, and irradiates the substrate P held in the substrate stage with the exposing light EL that has transited the mask M via the projecting optical system PL and the liquid LQ. By this means, the pattern image of the mask M is projected onto the substrate P, and the substrate P is exposed.

The exposure apparatus EX of the present embodiment is a scanning exposure apparatus (a so-called scanning stepper) which projects the pattern image of the mask M onto the substrate P while simultaneously moving the mask M and substrate P in a prescribed scanning direction. In the present embodiment, the scanning direction (simultaneous movement direction) of the substrate P is set to the Y-axis direction, and the scanning direction (simultaneous movement direction) of the mask M is also set to the Y-axis direction. In addition to moving the substrate P in the Y-axis direction relative to the projection region of the projecting optical system PL, the exposure apparatus EX moves the mask M in the Y-axis direction relative to the illumination region of the illumination system IL simultaneous with the movement in the Y-axis direction of the substrate P, irradiates the substrate P with the exposing light EL via the projecting optical system PL and the liquid LQ, and exposes the substrate P.

As described above, by irradiating the member S with ultraviolet light Lu and imparting energy to the member S (film Sf) in a state where the surface of the member S has been brought into contact with a prescribed fluid such as nitrogen gas, it is possible to reduce the surface energy of the member S (film Sf) and to restore the liquid repellency of the surface of the member S (film Sf). Accordingly, when conducting immersion exposure processing or measurement processing for purposes of immersion exposure processing, by using a member S after it has been subjected to treatment by the surface treatment apparatus 80A, it is possible to inhibit residue of the liquid LQ on the member S, and to maintain the liquid immersion space LS in the desired state. Accordingly, it is possible to maintain the performance of the exposure apparatus EX, satisfactorily expose the substrate P while inhibiting the occurrence of exposure defects, and manufacture devices having the desired performance.

In the present embodiment, in order to reduce the surface energy of the member S, energy is imparted to the member S by irradiating the surface of the member S with ultraviolet light Lu in a state where the surface of the member S has been brought into contact with a prescribed fluid. By employing light which has substantially the same wavelength as the exposing light EL (ArF excimer laser light) or which has a wavelength shorter than the exposing light EL as the ultraviolet light Lu which is employed, it is possible to efficiently impart energy to the member S.

The light Lu with which irradiation is conducted in order to impart energy to the member S does not have to be ultraviolet light. For example, in the case where the exposing light EL with which the member S is irradiated in a state of contact with the liquid LQ is not ultraviolet light, it is possible to efficiently impart energy to the member S by employing light which has substantially the same wavelength as the exposing light EL (which is not ultraviolet light) or which has a wavelength shorter than the exposing light EL as the light Lu with which irradiation is conducted in order to impart energy to the member S.

In addition, the light Lu with which irradiation is conducted in order to impart energy to the member S may also be light which has a longer wavelength than the wavelength of the exposing light EL (including ultraviolet light). By irradiating the member S with light Lu, the member S is heated, and energy is imparted to the member S based on this heat. Accordingly, it is possible to reduce the surface energy of the member S by energy based on irradiation with the light Lu in a state where the surface of the member S has been brought into contact with a prescribed fluid (such as nitrogen gas).

In the present embodiment, nitrogen gas is used as the prescribed fluid which is brought into contact with the surface of the member S when performing surface treatment in order to reduce the surface energy of the member S, but it is also acceptable to use a fluid with a smaller polarity than the liquid LQ (water) as the prescribed fluid. For example, as the prescribed fluid, it is also acceptable to use inert gas such as argon gas. Inert gas such as nitrogen gas and argon gas are almost non-polar, and are suited for use in the surface treatment method pertaining to the present embodiment. Moreover, in addition to inert gas such as nitrogen gas and argon gas, it is also possible to use the gas of one's choice if the gas has a polarity smaller than that of the liquid LQ.

Moreover, it is also possible to use a dry gas as the prescribed fluid which is brought into contact with the surface of the member S. By this means, it is possible to further reduce the surface energy of the member S.

As the prescribed fluid which is brought into contact with the surface of the member S, one is not limited to gases, and it is also acceptable to employ liquids if it is a fluid which has a smaller polarity than the liquid LQ (water). For example, fluoro liquids (fluids) such as perfluorinated polyether (PFPE) and fluorooils are acceptable.

In the present embodiment, a description was given of an example where water is used as the liquid that serves to fill the optical path space of the exposing light EL, but liquids other than water are also acceptable. For example, as the liquid LQ, one may use liquids with a refractive index on the order of 1.6 to 1.8. As the liquid LQ, one may use a variety of fluids - for example, supercritical fluids. Moreover, as the liquid LQ, it is also possible to use liquids which are stable relative to the projecting optical system PL or a film Rg of photosensitive material forming the surface of the substrate P (such as hydrofluoroether (HFE), perfluorinated polyether (PFPE), and fonbrin oil). The film Sf of the member S or the prescribed fluid which is brought into contact with the surface of the member S at the time of surface treatment designed to reduce the surface energy of or the member S is determined according to the liquid LQ (physical properties and the like of the liquid LQ).

In the present embodiment, the surface of the member S is formed with a liquid-repellent film Sf, but the entirety of the member S may be formed with material having liquid repellency. For example, the entirety of the plate member T of the substrate table 12 may be formed with material having liquid repellency - for example, material including PFA (tetrafluoro ethylene-perfluoro alkylvinyl ether copolymer) or the like. It is then possible to restore liquid repellency by treating the surface of such a plate member T by the surface treatment method of the present embodiment.

### <Second embodiment>

Next, a second embodiment is described. In the below description, the same code numbers are given to components which are identical or equivalent to those of the above-described embodiment, and description thereof is abridged or omitted.

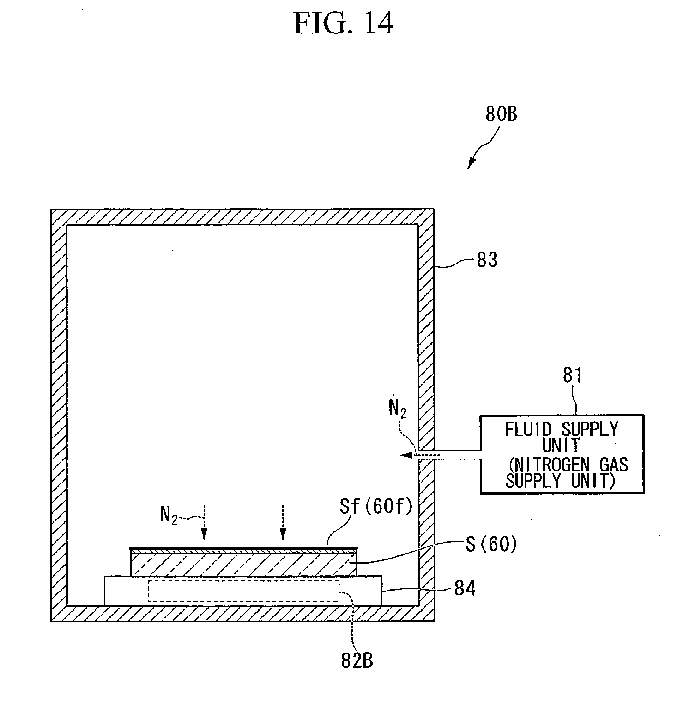

FIG 14 is a drawing which shows the surface treatment apparatus 80B of the second embodiment. In FIG 14, the surface treatment apparatus 80B is provided with a fluid supply unit 81 which supplies a prescribed fluid so that it contacts the surface of the member S, and an energy supply unit 82B which imparts energy to the member S in a state where the surface of the member S has been brought into contact with the prescribed fluid in order to reduce the surface energy of the member S. The surface treatment apparatus 80B is also provided with a chamber unit 83 capable of housing the member S, and a holder member 84 which is disposed inside the chamber unit 83 and which holds the bottom face (rear face) of the member S.

In the present embodiment, the fluid supply unit 81 includes a nitrogen gas supply unit which supplies dry nitrogen gas. The fluid supply unit 81 supplies nitrogen gas to the interior of the chamber unit 83. The nitrogen gas supplied to the interior of the chamber unit 83 by the fluid supply unit 81 is conveyed to the surface of the member S held in the holder member 84 inside the chamber unit 83, and contacts the surface of the member S. The fluid supply unit 81 may also supply gas other than nitrogen gas such as argon gas, and it may also supply liquids that have a smaller polarity than that of the liquid LQ.

In the present embodiment, the energy supply unit 82B includes a heating unit capable of heating the member S. In the present embodiment, at least part of the heating unit 82B is provided in the holder member 84. The heating unit 82B is capable of heating the member S held in the holder member 84.

The heating unit 82B is capable of heating the surface (film Sf) of the member S in a state of contact with the nitrogen gas by heating the member S which is held in the holder member 84. The surface energy of the member S is reduced by supplying energy based on the heat supplied from the heating unit 82B to the film Sf which forms the surface of the member S in a state of contact with the nitrogen gas.

In the present embodiment, energy is imparted to the member S by heating the member S with the energy supply unit 82B, but it is also acceptable to impart energy to the member S by, for example, supplying a heated fluid to the surface of the member S. By this means, the surface energy of the member S is reduced. For example, it is possible to supply heated gas (nitrogen gas and the like).

### <Third embodiment>

Next, a third embodiment, usable with the present invention, is described. In the below description, the same code numbers are given to components which are identical or equivalent to those of the above-described embodiments, and description thereof is abridged or omitted.

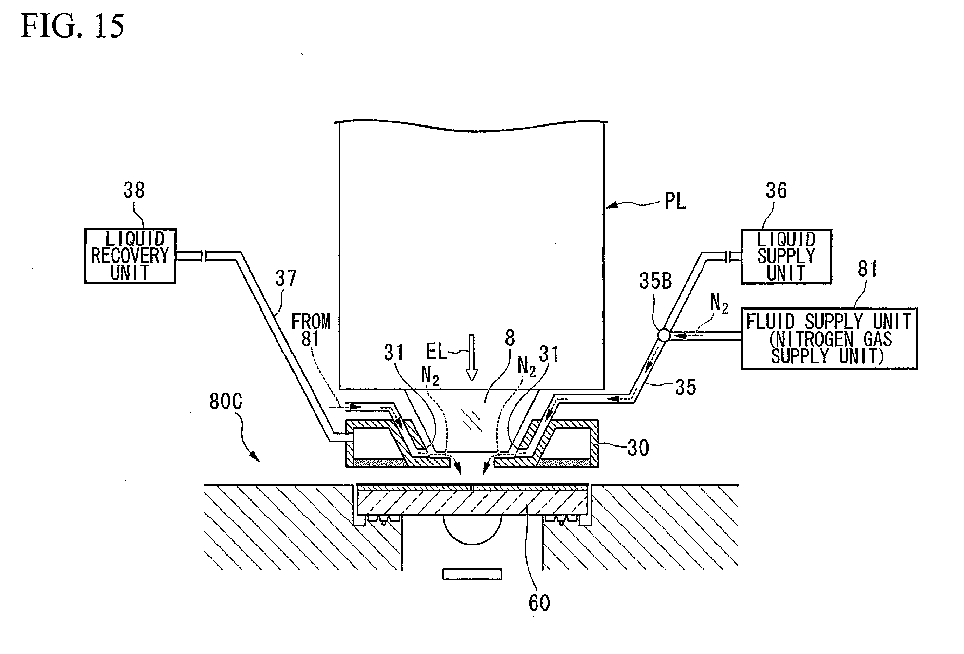

FIG 15 is a drawing which shows the surface treatment apparatus 80C of the third embodiment. The surface treatment apparatus 80C of the third embodiment includes a nozzle member 30 which is disposed in proximity to the first optical element 8, and which is capable of forming a liquid immersion space LS so that the optical path space of the exposing light EL on the light-emitting face side of the first optical element 8 is filled with the liquid LQ. In the present embodiment, the fluid supply unit 81 is connected to a prescribed position of the supply tube 35 via a valve mechanism (channel switching mechanism) 35B. In the present embodiment, the fluid supply unit 81 includes a nitrogen gas supply unit which supplies dry nitrogen gas.

The valve mechanism 35B closes the channel which connects the supply port 31 and the fluid supply unit 81 in a state where the channel which connects the supply port 31 and the liquid supply unit 36 is open, and opens the channel which connects the supply port 31 and the fluid supply unit 81 in a state where the supply port 31 and the liquid supply unit 36 are closed. The operation of the valve mechanism 35 is controlled by the controller 7.

Next, a description is given of one example of the operation of the exposure apparatus EX of the third embodiment. Below, a description is given for the case where surface treatment is conducted on the slit plate 60. As with the above-described embodiments, when measurement processing using the slit plate 60 is conducted, the controller 7 compels the light-emitting face of the first optical element 8 and the slit plate 60 to face opposite each other, and forms the liquid immersion space LS using the nozzle member 30. When forming the liquid immersion space LS, the controller 7 uses the valve mechanism 35 to close the channel which connects the supply port 31 and the fluid supply unit 81.

In the case where surface treatment is performed for purposes of reducing the surface energy of the slit plate 60 using the surface treatment apparatus 80C containing the nozzle member 30, the controller 7 stops the operation of the liquid supply unit 36, and stops the supply operation of the liquid LQ from the supply port 31 by controlling the valve mechanism 35B and so on. The controller 7 then removes the liquid LQ from the surface of the slit plate 60 by conducting a liquid recovery operation using the recovery port 32.

After removing the liquid LQ from the surface of the slit plate 60, the controller 7 uses the valve mechanism 35B to open the channel which connects the supply port 31 and the fluid supply unit 81. The controller 7 then dispatches the fluid (nitrogen gas) from the fluid supply unit 81 in a state where the slit plate 60 is disposed at the location of the first position which faces opposite the light-emitting face of the first optical element 8.

The fluid (nitrogen gas) which is dispatched from the fluid supply unit 81 is supplied to the supply port 31 via the supply tube 35 and the supply channel formed inside the nozzle member 30. The supply port 31 supplies the fluid (nitrogen gas) from the fluid supply unit 81 so that it contacts the surface of the slit plate 60 disposed at the first position.

In parallel with the operation which supplies nitrogen gas from the supply port 31, the controller 7 causes the exposing light EL to be emitted from the illumination system IL, and to be received into the projecting optical system PL. By this means, the exposing light EL is emitted from the light-emitting face of the first optical element 8, and irradiates the surface of the slit plate 60.

In this manner, it is possible to reduce the surface energy of the slit plate 60 by disposing the slit plate 60 at the first position, and by irradiating the slit plate 60 with the exposing light EL (ultraviolet light) via the first optical element 8 in a state where the surface of the slit plate 60 has been brought into contact with the nitrogen gas from the supply port 31.

In the present embodiment, a description was given of an example where the member S which is treated with the surface treatment apparatus 80C is the slit plate 60, but it goes without saying that it is possible to treat the reference plate 50, upper plate 70, plate member T and so on with the surface treatment apparatus 80C, and reduce their surface energy (restore liquid repellency). These respective members are capable of moving to (capable of being disposed at) the first position which is opposite the light-emitting face of the first optical element 8, where it is possible to supply the nitrogen gas from the supply port 31 of the nozzle member 30, and to conduct irradiation with the exposing light EL from the first optical element 8.

In the present embodiment, the fluid supplied to the member S from the fluid supply unit 81 via the supply port 31 does not have to be nitrogen gas so long as its polarity is smaller than that of the liquid LQ - other gases such as argon gas may be used, and liquid may also be used. Moreover, air (dry air) is also acceptable as the fluid which is brought into contact with the surface of the member S when performing the surface treatment that reduces the surface energy of the member S. In the case where the space on the light-emitting face side of the first optical element 8 is an air space, even if the operation of fluid supply from the supply port 31 is omitted, and even if the various units and pieces of equipment such as the fluid supply unit 81 and the valve mechanism 35B are omitted, it is possible to bring the surface of the member S into contact with the fluid (air) when performing the surface treatment that reduces the surface energy of the member S.

### <Fourth embodiment>

Next, a fourth embodiment, usable with the present invention, is described. In the below description, the same code numbers are given to components which are identical or equivalent to those of the above-described embodiments, and description thereof is abridged or omitted.

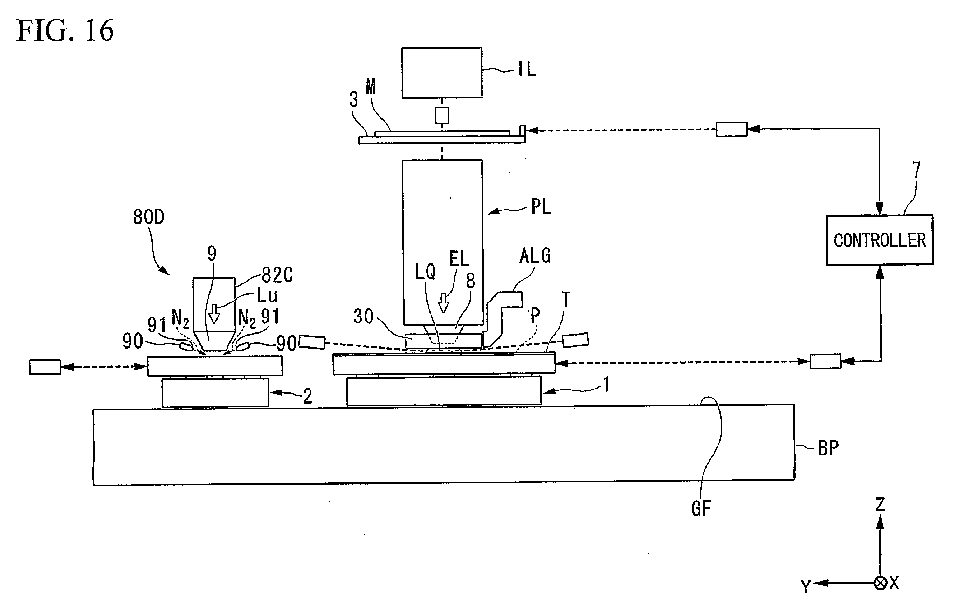

FIG 16 is a drawing which shows the exposure apparatus EX of the fourth embodiment. The exposure apparatus EX of the present embodiment is provided with a surface treatment apparatus 80D disposed at a position different from that of the projecting optical system PL. The surface treatment apparatus 80D is provided with a second optical element 9 which has a light-emitting face that emits ultraviolet light Lu, and which is disposed at a position different from that of the first optical element 8, and a supply member 90 which is disposed in proximity to the second optical element 9, and which has a supply port 91 capable of supplying a fluid such as nitrogen gas.

The substrate stage 1 is capable of moving within a prescribed region on the guide face GF which includes the first position opposite the light-emitting face of the first optical element 8, and a second position opposite the light-emitting face of the second optical element 9. The measurement stage 2 is capable of moving independently of the substrate stage 1 within the prescribed region on the guide face GF which includes the first position and the second position.

In the present embodiment, the surface treatment unit 80D which includes the second optical element 9 is disposed on the +Y side of the first optical element 8, and the measurement stage 2 is disposed on the +Y side of the substrate stage 1.

As with the above-described embodiments, when the substrate stage 1 and second substrate stage 2 are respectively moved to the first position, they come into contact with the liquid LQ of the liquid immersion space LS.

The surface treatment apparatus 80D has an ultraviolet light irradiation unit 82C which is capable of irradiating either the substrate stage 1 or measurement stage 2 disposed at the second position with ultraviolet light Lu via the second optical element 9. The ultraviolet light Lu emitted from the ultraviolet light irradiation unit 82C is received on the receiving face of the second optical element 9, and is emitted from the light-emitting face of the second optical element 9. The ultraviolet light Lu emitted from the light-emitting face of the second optical element 9 irradiates either the substrate stage 1 or measurement stage 2 disposed at the second position.

The fluid supply unit (nitrogen gas supply unit) is connected to the supply member 90. The fluid (nitrogen gas) dispatched from the fluid supply unit is supplied to the supply port 91 of the supply member 90. The supply port 91 of the supply member 90 supplies the fluid (nitrogen gas) either to the substrate stage 1 or measurement stage 2 disposed at the second position.

The surface treatment apparatus 80D supplies the nitrogen gas from the supply port 91 either to the substrate stage 1 or measurement stage 2 disposed at the second position, and irradiates its with ultraviolet light Lu via the second optical element 9 in a state where it has been brought into contact with the nitrogen gas.

As shown in FIG 16, in the present embodiment, the controller 7 is able to perform in parallel at least a portion of the operation which disposes the substrate stage 1 at the first position and which irradiates the substrate stage 1 with the exposing light EL in a state where it has been brought into contact with the liquid LQ, and the operation which disposes the measurement stage 2 at the second position and which irradiates the measurement stage 2 with ultraviolet light Lu. That is, in the present embodiment, the controller 7 is able to conduct in parallel the operation which conducts immersion exposure of the substrate P held in the substrate stage 1, and the surface treatment operation that serves to reduce the surface energy of the measurement stage 2.

### <Fifth embodiment>

Next, a fifth embodiment, usable with the present invention, is described. In the below description, the same code numbers are given to components which are identical or equivalent to those of the above-described embodiments, and description thereof is abridged or omitted.

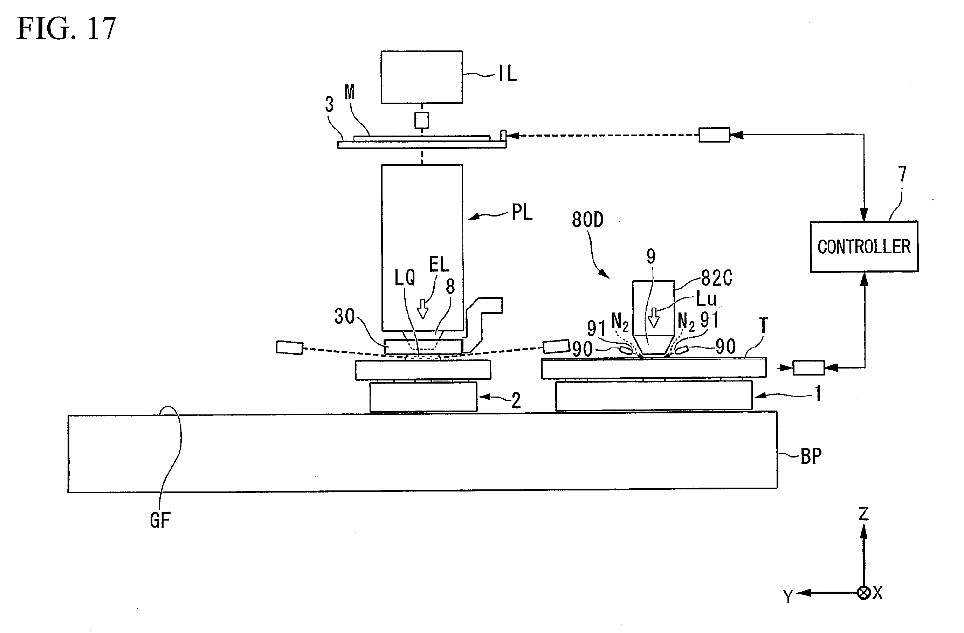

FIG 17 is a drawing which shows the exposure apparatus EX of the fifth embodiment. As with the above-described fourth embodiment, the exposure apparatus EX is provided with a second optical element 9 which has a light-emitting face that emits ultraviolet light Lu, and which is disposed at a position different from that of the first optical element 8, and a surface treatment apparatus 80D which has a supply member 90 that is disposed in proximity to the second optical element 9 and that has a supply port 91 capable of supplying a fluid such as nitrogen gas.

In the present embodiment the surface treatment apparatus 80D which contains the second optical element 9 is disposed on the -Y side of the first optical element 8, and the substrate stage 1 is disposed on the -Y side of the measurement stage 2.

As shown in FIG 17, in the present embodiment, the controller 7 is able to perform in parallel at least a portion of the operation which disposes the measurement stage 2 at the first position and which irradiates the measurement stage 2 with the exposing light EL in a state where it has been brought into contact with the liquid LQ, and the operation which disposes the substrate stage 1 at the second position and which irradiates the substrate stage 1 (plate member T, etc.) with ultraviolet light Lu. That is, in the present embodiment, the controller 7 is able to conduct in parallel a measurement operation using the measurement stage 2 and the surface treatment operation that serves to reduce the surface energy of substrate stage 1 (plate member T, etc.).

It is, of course, possible to combine the above-described fourth embodiment and fifth embodiment. That is, surface treatment apparatuses 80D can be disposed on the +Y side and -Y side, respectively, of the projecting optical system PL. By this means, surface treatment operations can be smoothly performed at the prescribed timing with respect to both the substrate stage 1 and measurement stage 2.

In each of the above-described embodiments, a description was made with respect to periodic performance of surface treatment operation for purposes of reducing the surface energy of the member S, but it is also acceptable, for example, to obtain images (optical images) of the member S by the alignment system ALG; and to decide whether or not the surface treatment operation is to be performed for purposes of reducing the surface energy of the member S based on the obtained image information. As stated above, the alignment system ALG of the present embodiments has a photographic element such as a CCD, and is capable of obtaining images of the member S. When the surface energy of the member S increases (when the liquid repellency of the surface of the member S deteriorates), the possibility is high that liquid LQ (droplets) remain on the surface of the member S, regardless of whether operations to remove the liquid LQ from the surface of the member S have been performed. In the case where - based on image information pertaining to the surface of the member S acquired using the alignment system ALG - the controller 7 judges, for example, that liquid LQ (droplets) remains on the surface of the member S despite the fact that operations to remove the liquid LQ from the surface of the member S have been conducted, it judges (presumes) that the liquid repellency of the surface of the member S has deteriorated, and performs the surface treatment operation to reduce the surface energy of the member S.

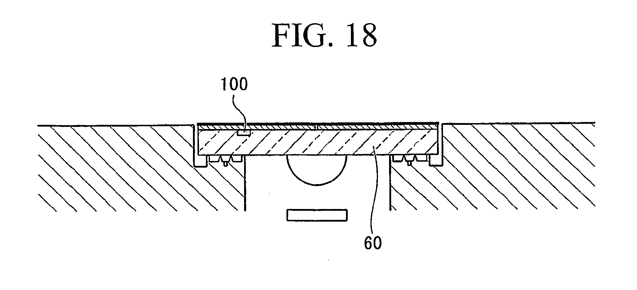

As shown in FIG 18, it is also acceptable to provide a temperature sensor 100 on the member S (in this case, slit plate 60) which is capable of detecting the temperature of the surface of the member S, and decide whether or not to perform the surface treatment operation to reduce the surface energy of the member S based on the detection results of the temperature sensor 100. When the surface energy of the member S increases (when the liquid repellency of the surface of the member S deteriorates), the possibility is high that liquid LQ (droplets) remain on the surface of the member S regardless of whether operations to remove the liquid LQ from the surface of the member S have been performed, and the possibility of a large variation (decline) in the temperature of the surface of the member S due to evaporative heat of the liquid LQ residue is high. In the case where the controller 7 senses a major variation in the temperature of the surface of the member S based on the detection results of the temperature sensor 100, it judges (presumes) that liquid LQ (droplets) tends to remain on the surface of the member S, and performs the surface treatment operation to reduce the surface energy of the member S.

In the above-described first and second embodiments, the description was made such that the surface treatment apparatus 80A and 80B is provided in the exposure apparatus EX, but it may also constitute a separate apparatus from the exposure apparatus EX. Using the surface treatment apparatus 80A and 80B, it is acceptable not only to perform surface treatment on a member configuring an immersion exposure apparatus EX, but also on a member of a manufacturing apparatus which manufactures devices using liquid - for example, a coating applicator which coats a substrate with a solution containing photosensitive material and the like, or a developing apparatus which develops a substrate after exposure using developing solution and the like. By this means, it is possible to inhibit liquid residue on the surface of the various types of members configuring such manufacturing apparatuses, and to inhibit deterioration of the performance of the apparatuses.

With respect to the projecting optical system of the above-described embodiments, the optical path space on the image-face (light-emitting-face) side of the first optical element 8 at the tip is filled with liquid, but it is also acceptable to adopt a projecting optical system where the optical path space on the object-face (incident-face) side of the first optical element 8 at the tip is also filled with the liquid, as disclosed in PCT International Publication No. WO 2004/019128.

In each of the above-described embodiments, the respective positional information of the mask stage, substrate stage and measurement stage is measured using a measurement system (interferometer system) containing a laser interferometer, but one is not limited thereto, and it is also acceptable, for example, to use an encoder system which detects scales (diffraction gratings) provided in the respective stage. In this case, it is preferable to have a hybrid system which is provided with both an interferometer system and an encoder system, and to conduct calibration of measurement results of the encoder system using the measurement results of the interferometer system. In addition, it is acceptable to conduct positional control of the stages with alternate use of the interferometer system and encoder system, or using both.

In the above-described embodiments, the configuration of the immersion system such as the nozzle member is not limited to the above, and it is also possible to use, for example, the immersion systems disclosed in PCT International Publication No. WO 2004/086468 and PCT International Publication No. WO 2005/024517.

As the substrate P in each of the embodiments described above, one may apply not only semiconductor wafers for semiconductor device manufacturing, but also glass substrates for display devices, ceramic wafers for thin-film magnetic heads, or the original plates (synthetic quartz and silicon wafers) of masks or reticles used in exposure apparatuses, etc.

As the exposure apparatus EX, in addition to scanning exposure apparatuses (scanning steppers) of the step-and-scan method which synchronously move the mask M and substrate P, and conduct scanning exposure of the pattern of the mask M, it is also possible to apply projecting exposure apparatuses (steppers) of the step-and-repeat method which conduct one-shot exposure of the pattern of the mask M in a state where the mask M and the substrate P are stationary, and which move the substrate P in sequential steps.

Furthermore, in exposure of the step-and-repeat method, it is also acceptable to transfer a reduced image of a first pattern onto the substrate P using the projecting optical system in a state where the first pattern and the substrate P are almost stationary, after which one-shot exposure is conducted on the substrate P by conducting partial superimposition of a reduced image of a second pattern on the first pattern using the projecting optical system in a state where the second pattern and the substrate P are almost stationary (one-shot exposure apparatus of the stitch method). In addition, as the exposure apparatus of the stitch method, one may apply an exposure apparatus of the step-and-stitch method where at least two patterns are transferred with partial superimposition onto the substrate P, and the substrate P is sequentially moved.

The present invention can also be applied to an exposure apparatus of the multistage (twin-stage) type which is provided with multiple (two) substrate stages as disclosed in Japanese Patent Application, Publication No. H10-163099, Japanese Patent Application, Publication No. H10-214783, Published Japanese Translation No. 2000-505958 of the PCT International Publication.

The present invention can also be applied to an exposure apparatus which is not provided with a measurement stage, as disclosed in PCT International Publication No. WO 99/49504. In addition, it can also be applied to an exposure apparatus which is provided with a multiple substrate stages and measurement stages.

In the above-described embodiments, an exposure apparatus is adopted wherein the area between the projecting optical system PL and substrate P is locally filled with liquid, but the present invention can also be applied to an immersion exposure apparatus where exposure is conducted in a state where the entirety of the surface of the substrate targeted for exposure is submerged in liquid, as disclosed in Japanese Patent Application, Publication No. H6-124873, Japanese Patent Application, Publication No. H10-303114, and U.S. Patent No. 5,825,043 .

In each of the above-described embodiments, description was made citing the example of an exposure apparatus provided with a projecting optical system PL, but the present invention can also be applied to an exposure apparatus and exposure method which do not use a projecting optical system PL. In the case where the projecting optical system PL is not used, the substrate is irradiated with the exposing light via an optical member such as a lens, and a liquid immersion space is formed in a prescribed space between the optical member and the substrate.

As to the type of exposure apparatus EX, one is not limited to an exposure apparatus for manufacturing semiconductor elements which exposes semiconductor element patterns on the substrate P, and it is also possible to widely apply the present invention to exposure apparatuses for manufacturing liquid crystal display elements and for manufacturing displays, and to exposure apparatuses that serve to manufacture thin-film magnetic heads, photographic elements (CCDs), micro-machines, MEMS, DNA chips, or reticles, masks, etc.

In the above-described embodiments, an optically permeable mask was used which forms a prescribed lightproof pattern (or phase pattern or light-reducing pattern) on the substrate, but instead of this mask, it is also possible to use an electronic mask which forms a permeable pattern or reflective pattern or light-emitting pattern based on electronic data of the pattern to be exposed (also referred to as a variable-shaped mask, including, e.g., a DMD (digital micro-mirror device) which is a type of non-light-emitting image display element (spatial light modulator)), as disclosed, for example, in U.S. Patent No. 6,778,257.

In addition, the present invention may be applied to an exposure apparatus (lithography system) which exposes a line-and-space pattern on the substrate P by forming an interference fringe on the substrate P, as disclosed, for example, in PCT International Publication No. WO 2001/035168.

The present invention may also be applied to an exposure apparatus which combines two mask patterns on a substrate via a projecting optical system, and which almost simultaneously conducts double exposure in one shot region on a substrate by a single scanning exposure, as disclosed, for example, in Published Japanese Translation No. 2004-519850 of the PCT International Publication (corresponding U.S. Patent No. 6,611,316).

The exposure apparatus EX of the embodiments of the present application described above is manufactured by assembling the various subsystems containing the respective components cited in the Claims section of this application so that the prescribed mechanical accuracy, electrical accuracy and optical accuracy are maintained. In order to secure these respective types of accuracy, before and after this assembly, the respective types of optical systems are adjusted in order to achieve optical accuracy, the respective types of mechanical systems are adjusted in order to achieve mechanical accuracy, and the respective types of electrical systems are adjusted in order to achieve electrical accuracy. The assembly process from the various subsystems up to the exposure apparatus includes subjecting the various subsystems to mutual mechanical connection, wiring connection of electrical lines, piping connection of pneumatic lines, and so on. Prior to this process of assembly from the various subsystems to the exposure apparatus, it goes without saying that there is an individual assembly process for each subsystem. When the process of assembling the various subsystems into the exposure apparatus is completed, integrated adjustments are conducted to secure the various types of accuracy pertaining to the overall exposure apparatus. It is preferable that the manufacture of the exposure apparatus be conducted in a clean room where temperature, cleanliness and the like are managed.

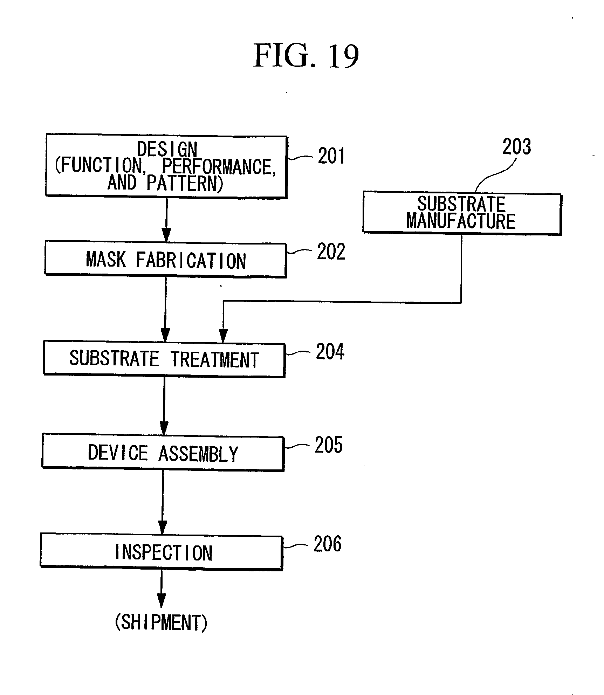

As shown in FIG 19, a microdevice such as a semiconductor device is manufactured via a step 201 wherein the function and performance design of the microdevice is conducted, a step 202 wherein the mask (reticle) is fabricated based on this design step, a step 203 wherein the substrate which is the base material of the device is manufactured, a substrate treatment step 204 wherein the mask pattern is exposed on the substrate according to the above-described embodiments, and which includes substrate treatment (exposure treatment) which develops the exposed substrate, a device assembly step (dicing process, bonding process, packaging process, etc.) 205, an inspection step 206 and the like.

Further preferred embodiments in accordance with the disclosure are given in the following paragraphs:

A first further preferred embodiment in accordance with the disclosure is a surface treatment method of an object that has a surface with liquid repellency, the method comprising: imparting energy to the object in a state where the surface of the object has been brought into contact with a prescribed fluid in order to reduce the surface energy of the object.

In a first aspect of the first further preferred embodiment, said surface of the object is formed with a film of material containing fluorine. Said surface energy of the object, which had increased by irradiation with ultraviolet light in a state where the object was in contact with a liquid, may be reduced. This sub-aspect of the first aspect of the first further preferred embodiment forms a second further preferred embodiment .

In a second aspect of the first further preferred embodiment , said prescribed fluid is gaseous. Said prescribed fluid may comprise inert gas, e.g., nitrogen gas.

In a first aspect of the second further preferred embodiment, said liquid comprises water.

In a second aspect of the second further preferred embodiment, said liquid has polarity. This second aspect of the second further preferred embodiment forms a third further preferred embodiment.

In a first aspect of the third further preferred embodiment , said material of the film comprises intramolecular polar parts.

In a second aspect of the third further preferred embodiment, said prescribed fluid is a fluid of smaller polarity than the liquid. Said prescribed fluid may be substantially nonpolar and/or gaseous. Further, said prescribed fluid may comprise inert gas, e.g. nitrogen gas.

In a third aspect of the first further preferred embodiment, said impartation of energy comprises conducting irradiation with light. Said light might comprise ultraviolet light.

In a third aspect of the second further preferred embodiment, said impartation of energy comprises conducting irradiation with light, and the wavelength of the light which irradiates the object in the impartation of energy is identical to the wavelength of ultraviolet light which irradiates the object in a state of contact with the liquid, or is shorter than the wavelength of the ultraviolet light.

In a fourth aspect of the first further preferred embodiment, said impartment of energy comprises heating.

A fourth further preferred embodiment is a surface treatment method of an object having a surface formed with liquid-repellent film, the method comprising: irradiating the film with ultraviolet light in a state where the film has been brought into contact with a prescribed fluid, in order to restore the liquid repellency of the film which had undergone a reduction in the liquid repellency.

A fifth further preferred embodiment is a surface treatment apparatus of an object that has a surface with liquid-repellency, comprising: a fluid supply unit that supplies a prescribed fluid so that the fluid contacts the surface of the object; and an energy supply unit that imparts energy to the object in a state where the surface of the object has been brought into contact with the prescribed fluid in order to reduce the surface energy of the object.

In a first aspect of the fifth further preferred embodiment, said fluid supply unit supplies dry nitrogen gas.

In a second aspect of the fifth further preferred embodiment, said energy supply unit comprises an ultraviolet light irradiation apparatus which conducts irradiation with ultraviolet light.

A sixth further preferred embodiment is an exposure method for exposing a substrate by irradiating the substrate with exposing light via a liquid, the method comprising: treating the surface of an object by the surface treatment method according to any aspect of the first to third further preferred embodiments, the object arranged at a position that allows the object to be irradiated with the exposing light.

A seventh further preferred embodiment is an exposure method for exposing a substrate by irradiating the substrate with exposing light via a liquid, the method comprising: irradiating the surface of an object with the exposing light via the liquid in a state where the surface of the object arranged at a position that allows the object to be irradiated with the exposing light has been brought into contact with the liquid, and imparting energy to the object in a state where the surface of the object has been brought into contact with a prescribed fluid in order to reduce the surface energy of the object which had been increased by irradiation with the exposing light in a state where the object was in contact with the liquid.

In a first aspect of the seventh further preferred embodiment, said imparting of energy to the object is conducted after the liquid has been removed from the surface of the object.

In a second aspect of the seventh further preferred embodiment, said prescribed fluid is gaseous, e.g. nitrogen gas.

In a third aspect of the seventh further preferred embodiment, said liquid comprises water.

In a fourth aspect of the seventh further preferred embodiment, said imparting of energy comprises conducting irradiation with ultraviolet light. Said exposing light may comprise the ultraviolet light.

An eighth further preferred embodiment is a device manufacturing method using the exposure method according to any aspect of the seventh further preferred embodiment.

A ninth further preferred embodiment is an exposure apparatus that exposes a substrate by irradiating the substrate with exposing light via a liquid, comprising: a surface treatment apparatus according to any aspect of the fifth further preferred embodiment .

A tenth further preferred embodiment is an exposure apparatus that exposes a substrate by irradiating the substrate with exposing light via a liquid, comprising: an object that is to be irradiated with the exposing light in a state where the object is in contact with the liquid, and a surface treatment apparatus that imparts energy to the object in a state where the surface of the object has been brought into contact with a prescribed fluid in order to reduce the surface energy of the object which had been increased by irradiation with the exposing light in a state where the object was in contact with the liquid.

In a first aspect of the tenth further preferred embodiment , said surface of the object is formed with a film of material containing fluorine.

In a second aspect of the tenth further preferred embodiment, said prescribed fluid comprises nitrogen gas.

In a third aspect of the tenth further preferred embodiment , said liquid comprises water.

In a fourth aspect of the tenth further preferred embodiment, energy is imparted to the object by having the surface treatment apparatus irradiate the object with ultraviolet light in a state where the prescribed fluid and the surface of the object have been brought into contact.

In a fifth aspect of the tenth further preferred embodiment, said exposure apparatus further comprises: a first optical member which has a light-emitting face that emits the exposing light, wherein the object is an object capable of moving within a prescribed region including a first position which is opposite to a light-emitting face of the first optical member. This fifth aspect of the tenth further preferred embodiment forms an eleventh further preferred embodiment.

In a first aspect of the eleventh further preferred embodiment, said exposing light comprises the ultraviolet light, and the energy is imparted to the object by conducting irradiation with the exposing light via the first optical member in a state where the object is located at the first position. Said exposure apparatus may further comprise: an immersion space formation member that is disposed in the vicinity of the first optical member, and between which and the object an immersion space can be formed so that the optical path on the light-emitting face side of the first optical member is filled with liquid; and a supply port that is formed in the immersion space formation member, and that is capable of supplying the prescribed fluid.

In a second aspect of the eleventh further preferred embodiment, said object comprises at least part of a measurement stage that is capable of moving and that is equipped with a gauge which is capable of conducting measurement relating to exposure. Said object may comprise a measurement member that is removably held in the measurement stage, and that serves to conduct measurement relating to exposure where irradiation is conducted with the exposing light in a state where the measurement member contacts the liquid.

In a third aspect of the eleventh further preferred embodiment, said object comprises at least part of a substrate stage that is capable of moving while holding the substrate. Said object may comprise a plate-like member that is removably held in the substrate stage, and that is arranged at the periphery of the substrate when irradiation is conducted with the exposing light via the liquid.

In a fourth aspect of the eleventh further preferred embodiment, said exposure apparatus comprises: a first optical member that has a light-emitting face from which the exposing light is emitted; a second optical member that has a light-emitting face from which the ultraviolet light is emitted, and that is disposed at a position different from the first optical member; a first mover that is capable of moving within a prescribed region that comprises a first position which is opposite the light-emitting face of the first optical member, and a second position which is opposite the light-emitting face of the second optical member; and a second mover that is capable of independent movement relative to the first mover within the prescribed region, and wherein the object comprises at least one of the first mover and the second mover. Said exposure apparatus may comprise a supply port which is disposed in the vicinity of the second optical member, and that is capable of supplying the prescribed fluid. At least one of the first mover and the second mover may contact the liquid when moved to the first position. An operation where the first mover is positioned at the first position, and irradiation is conducted with the exposing light in a state where liquid contacts the first mover may be executed in parallel with at least a portion of an operation where the second mover is positioned at the second position, and the second mover is irradiated with the ultraviolet light. Further, one of the first mover and the second mover may be a substrate stage that is capable of moving while holding the substrate, and the other mover is a measurement stage that is capable moving and that is equipped with a gauge which is capable of conducting measurement relating to exposure. Said object may comprise at least one of a plate-like member and a measurement member, the plate-like member being removably held in the substrate stage and arranged at the periphery of the substrate when irradiation is conducted with the exposing light via the liquid, the measurement member being removably held in the measurement stage and serving to conduct measurement relating to exposure where irradiation is conducted with the exposing light in a state where the measurement member contacts the liquid.

A twelfth further preferred embodiment is a device manufacturing method using an exposure apparatus according to any aspect of the ninth to eleventh further preferred embodiment.

## Claims

1. A surface treatment method of an object (60) that has a surface (60f) with liquid repellency, the method comprising:
imparting energy to the object (60) in a state where the surface (60f) of the object (60) is in contact with a prescribed fluid in order to reduce a surface energy of the object (60),
wherein the surface (60f) of the object (60) is formed with a film of material comprising fluorine and/or intramolecular polar parts;
wherein the prescribed fluid comprises inert gas;
wherein the surface energy of the object (60), which had increased by an exposure light (EL) in a state where the object was in contact with a liquid which has polarity, is reduced; and
wherein the impartment of energy comprises heating.

2. The surface treatment method according to claim 1, wherein the prescribed fluid comprises nitrogen gas.

3. The surface treatment method according to claims 1 or 2, wherein the liquid comprises water.

4. The surface treatment method according to any one of claims 1 to 3, wherein the prescribed fluid is a fluid of smaller polarity than the liquid.

5. The surface treatment method according to claim 4, wherein the prescribed fluid is substantially nonpolar.

6. A surface treatment apparatus (80B) in combination with an object (60) that has a surface with liquid repellency, comprising:
a fluid supply unit (81) that is configured to supply a prescribed fluid so that the prescribed fluid contacts the surface (60f) of the object (60); and
an energy supply unit (82B) that is configured to impart energy to the object (60) in a state where the surface (60f) of the object is in contact with the prescribed fluid; and
a controller (7) that is configured to control the surface treatment apparatus (80B);
wherein the surface of the object (60) is formed with a film of material comprising fluorine and/or intramolecular polar parts;
wherein the prescribed fluid comprises inert gas;
wherein the impartment of energy comprises heating; and
wherein the controller is configured to control the surface treatment apparatus (80B) to impart energy to the object in a state where the surface of the object is in contact with the prescribed fluid, such that the surface energy of the object (60), which had increased by an exposure light (EL) in a state where the object (60) was in contact with a liquid which has polarity, is reduced.

7. An exposure apparatus that is configured to expose a substrate (P) by irradiating the substrate (P) with exposing light (EL) via a liquid, comprising:
an object (60) that is to be irradiated with the exposing light (EL) in a state where the object(60) is in contact with the liquid, and
a surface treatment apparatus (80B) according to claim 6.

8. An exposure method for exposing a substrate (P) by irradiating the substrate with exposing light (EL) via a liquid, the method comprising:
irradiating the surface (60f) of an object (60) with the exposing light via the liquid in a state where the surface (60f) of the object (60) arranged at a position that allows the object (60) to be irradiated with the exposing light (EL) is in contact with the liquid, and
applying the method according to anyone of claims 1 to 5.

## Patentansprüche

1. Oberflächenbehandlungsverfahren für ein Objekt (60), welches eine Oberfläche (60f) mit Flüssigkeitsabweisungsvermögen aufweist, wobei das Verfahren aufweist:
Zuführen von Energie zu dem Objekt (60) in einem Zustand, in welchem die Oberfläche (60f) des Objekts (60) in Kontakt ist mit einem vorgegebenen Fluid, um eine Oberflächenenergie des Objekts (60) zu reduzieren,
wobei die Oberfläche (60f) des Objekts (60) mit einem Film eines Materials ausgebildet ist, welches Fluor und/oder intramolekulare polare Teile aufweist;
wobei das vorgegebene Fluid Inertgas aufweist;
wobei die Oberflächenenergie des Objekts (60), welche in einem Zustand, in welchem das Objekt in Kontakt mit einer Flüssigkeit, welche eine Polarität aufweist, war, mittels eines Belichtungslichts (EL) erhöht worden war, reduziert wird; und
wobei das Zuführen von Energie Heizen aufweist.

2. Das Oberflächenbehandlungsverfahren gemäß Anspruch 1, wobei das vorgegebene Fluid Stickstoffgas aufweist.

3. Das Oberflächenbehandlungsverfahren gemäß Anspruch 1 oder 2, wobei die Flüssigkeit Wasser aufweist.

4. Das Oberflächenbehandlungsverfahren gemäß einem der Ansprüche 1 bis 3, wobei das vorgegebene Fluid ein Fluid mit kleinerer Polarität als die Flüssigkeit ist.

5. Das Oberflächenbehandlungsverfahren gemäß Anspruch 4, wobei das vorgegebene Fluid im Wesentlichen unpolar ist.

6. Eine Oberflächenbehandlungsvorrichtung (80B) in Kombination mit einem Objekt (60), welches eine Oberfläche mit Flüssigkeitsabweisungsvermögen aufweist, aufweisend:
eine Fluidversorgungseinheit (81), welche ausgestaltet ist, ein vorgegebenes Fluid bereitzustellen, so dass das vorgegebene Fluid die Oberfläche (60f) des Objekts (60) kontaktiert; und
eine Energieversorgungseinheit (82B), welche ausgestaltet ist, dem Objekt (60) Energie zuzuführen in einem Zustand, in welchem die Oberfläche (60f) des Objekts in Kontakt mit dem vorgegebenen Fluid ist; und
eine Steuerung (7), welche ausgestaltet ist, die Oberflächenbehandlungsvorrichtung (80B) zu steuern;
wobei die Oberfläche des Objekts (60) mit einem Film von Material ausgebildet ist, welches Fluor und/oder intramolekulare polare Teile aufweist;
wobei das vorgegebene Fluid Inertgas aufweist;
wobei das Zuführen von Energie Heizen aufweist; und
wobei die Steuerung ausgestaltet ist, die Oberflächenbehandlungsvorrichtung (80B) zu steuern, dem Objekt Energie zuzuführen in einem Zustand, in welchem die Oberfläche des Objekts in Kontakt mit dem vorgegebenen Fluid ist, so dass die Oberflächenenergie des Objekts (60), welche mittels eines Belichtungslichts (EL) erhöht worden war in einem Zustand, in welchem das Objekt (60) in Kontakt mit einer Flüssigkeit war, welche Polarität aufweist, reduziert wird.

7. Eine Belichtungsvorrichtung, welche ausgestaltet ist, ein Substrat (P) mittels Beleuchtens des Substrats (P) mit Belichtungslicht (EL) durch eine Flüssigkeit zu belichten, aufweisend:
ein Objekt (60), welches mit dem Belichtungslicht (EL) in einem Zustand belichtet wird, in welchem das Objekt (60) in Kontakt mit der Flüssigkeit ist, und
eine Oberflächenbehandlungsvorrichtung (80B) gemäß Anspruch 6.

8. Ein Belichtungsverfahren zum Belichten eines Substrats (P) mittels Belichtens des Substrats mit Belichtungslicht (EL) durch eine Flüssigkeit, wobei das Verfahren aufweist:
Belichten der Oberfläche (60f) eines Objekts (60) mit dem Belichtungslicht durch die Flüssigkeit in einem Zustand, in welchem die Oberfläche (60f) des Objekts (60), welches an einer Position angeordnet ist, welche es ermöglicht, dass das Objekt (60) mit dem Belichtungslicht (EL) belichtet wird, in Kontakt mit der Flüssigkeit ist, und
Anwenden des Verfahrens gemäß einem der Ansprüche 1 bis 5.

## Revendications

1. Procédé de traitement de surface d'un objet (60) qui présente une surface (60f) avec une résistance au mouillage par un liquide, le procédé comprenant :
la transmission d'énergie à l'objet (60) dans un état où la surface (60f) de l'objet (60) est en contact avec un fluide prescrit pour réduire l'énergie de surface de l'objet (60),
dans lequel la surface (60f) de l'objet (60) est formée d'un film d'un matériau comprenant du fluor et/ou des parties polaires intramoléculaires;
dans lequel le fluide prescrit comprend un gaz inerte ;
dans lequel l'énergie de surface de l'objet (60), qui avait augmenté par une lumière d'exposition (EL) dans un état où l'objet a été en contact avec un liquide qui présente une polarité, est réduite ; et
dans lequel la transmission d'énergie comprend un chauffage.

2. Procédé de traitement de surface selon la revendication 1, dans lequel le fluide prescrit comprend du gaz azote.

3. Procédé de traitement de surface selon la revendication 1 ou la revendication 2, dans lequel le liquide comprend de l'eau.

4. Procédé de traitement de surface selon l'une quelconque des revendications 1 à 3, dans lequel le fluide prescrit est un fluide qui présente une polarité plus petite que celle du liquide.

5. Procédé de traitement de surface selon la revendication 4, dans lequel le fluide prescrit est sensiblement non polaire.

6. Appareil de traitement de surface (80B) en association avec un objet (60) qui présente une surface avec une résistance au mouillage par un liquide, comprenant :
une unité d'approvisionnement en fluide (81) qui est configurée pour fournir un fluide prescrit de sorte que le fluide prescrit entre en contact avec la surface (60f) de l'objet (60) ; et
une unité de fourniture d'énergie (82B) qui est configurée pour transmettre de l'énergie à l'objet (60) dans un état où la surface (60f) de l'objet est en contact avec le fluide prescrit ; et
un dispositif de commande (7) qui est configuré pour commander l'appareil de traitement de surface (80B) ;
dans lequel la surface de l'objet (60) est formée d'un film d'un matériau comprenant du fluor et/ou des parties polaires intramoléculaires ;
dans lequel le fluide prescrit comprend un gaz inerte ;
dans lequel la transmission d'énergie comprend un chauffage ; et
dans lequel le dispositif de commande est configuré pour commander l'appareil de traitement de surface (80B) afin de transmettre de l'énergie à l'objet dans un état où la surface de l'objet est en contact avec le fluide prescrit, de sorte que l'énergie de surface de l'objet (60), qui avait augmenté par une lumière d'exposition (EL) dans un état où l'objet (60) a été en contact avec un liquide qui présente une polarité, est réduite.

7. Appareil d'exposition qui est configuré pour exposer un substrat (P) en irradiant le substrat (P) avec une lumière d'exposition (EL) par l'intermédiaire d'un liquide, comprenant :
un objet (60) qui doit être irradié avec la lumière d'exposition (EL) dans un état où l'objet (60) est en contact avec le liquide ; et
un appareil de traitement de surface (80B) selon la revendication 6.

8. Procédé d'exposition destiné à exposer un substrat (P) en irradiant le substrat avec une lumière d'exposition (EL) par l'intermédiaire d'un liquide, le procédé comprenant :
l'irradiation de la surface (60f) d'un objet (60) avec la lumière d'exposition par l'intermédiaire du liquide dans un état où la surface (60f) de l'objet (60) agencé au niveau d'une position qui permet d'irradier l'objet (60) avec la lumière d'exposition (EL), est en contact avec le liquide ; et
l'application du procédé selon l'une quelconque des revendications 1 à 5.
